# EUROPEAN PATENT APPLICATION

(11) **EP 4 672 320 A2**
(43) Date of publication of application: **31.12.2025**
(21) Application number: 25174137.7
(22) Date of filing: 05.05.2025
(51) Int. Cl.: H01L 23/15, H01L 23/498

(54) **INTEGRATED CIRCUIT PACKAGES INCLUDING SUBSTRATES WITH REINFORCED GLASS CORES**

(30) Priority: 25.06.2024 US 202418753177
(71) Applicant: INTEL Corporation, Santa Clara, CA 95054 (US)
(72) Inventor: Li, Yonggang, Chandler, 85248 (US); Tanaka, Hiroki, Gilbert, 85295 (US); May, Robert, Chandler, 85249 (US); Pietambaram, Srinivas, Chandler, 85249 (US); Seneviratne, Dilan, Phoenix, 85048 (US); Angoua, Bainye, Chandler, 85226 (US); Coryell, Gene, Maricopa, 85138 (US); Duan, Gang, Chandler, 85248 (US); Bryks, Whitney, Tempe, 85284 (US); Nie, Bai, Chandler, 85249 (US); Duong, Benjamin, Phoenix, 85044 (US); Chen, Haobo, Chandler, 85249 (US); Shan, Bohan, Chandler, 85226 (US); Marin, Brandon, Gilbert, 85234 (US)
(74) Representative: Goddar, Heinz J.

(57) **Abstract**

Disclosed herein are microelectronic assemblies including reinforced glass layers, as well as related devices and methods. In some embodiments, a microelectronic assembly may include a glass layer, having a first surface and an opposing second surface, and a through-glass via; a first material including a dielectric, a mold, or an epoxy on the first surface; a first conductive via, through the first material, having tapered sides and a smaller cross-section towards the first surface; a first dielectric layer, on the first material, including a first conductive pathway electrically coupled to the first conductive via; a second material including a dielectric, a mold, or an epoxy on the second surface; a second conductive via, through the second material, having tapered sides and a larger cross-section towards the second surface; and a second dielectric layer, on the second material, including a second conductive pathway electrically coupled to the second conductive via.

## Description

### TECHNICAL FIELD

The present disclosure relates to techniques, methods, and apparatus directed to substrates having an encapsulated glass core for heterogeneous integrated circuit (IC) packaging architecture.

### BACKGROUND

Electronic circuits when fabricated on a wafer of semiconductor material, such as silicon, are commonly called integrated circuits (ICs). The wafer with such ICs is typically cut into numerous individual dies. The dies may be packaged into an IC package containing one or more dies along with other electronic components such as resistors, capacitors, and inductors. The IC package may be integrated onto an electronic system, such as a consumer electronic system.

### BRIEF DESCRIPTION OF THE DRAWINGS

Embodiments will be readily understood by the following detailed description in conjunction with the accompanying drawings. To facilitate this description, like reference numerals designate like structural elements. Embodiments are illustrated by way of example, and not by way of limitation, in the figures of the accompanying drawings.
FIGS. 1A and 1B are schematic cross-sectional views of example microelectronic assemblies according to some embodiments of the present disclosure.
FIGS. 2A and 2B are schematic cross-sectional views of example microelectronic assemblies according to some embodiments of the present disclosure.
FIG. 3 is a schematic cross-sectional view of an example microelectronic assembly according to some embodiments of the present disclosure.
FIGS. 4A-4L are simplified cross-sectional views illustrating various manufacturing steps of an example microelectronic assembly according to some embodiments of the present disclosure.
FIGS. 5A-5D are simplified cross-sectional views illustrating various manufacturing steps of an example microelectronic assembly according to some embodiments of the present disclosure.
FIGS. 6A-6F are simplified cross-sectional views illustrating various manufacturing steps of an example microelectronic assembly according to some embodiments of the present disclosure.
FIGS. 7A-7K are simplified cross-sectional views illustrating various manufacturing steps of an example microelectronic assembly according to some embodiments of the present disclosure.
FIGS. 8A-8O are simplified cross-sectional views and top views illustrating various manufacturing steps of an example substrate according to some embodiments of the present disclosure.
FIGS. 9A-9G are simplified cross-sectional views and top views illustrating various manufacturing steps of an example substrate according to some embodiments of the present disclosure.
FIGS. 10A and 10B are simplified top views illustrating example arrangements of a manufacturing step of a microelectronic assembly according to some embodiments of the present disclosure.
FIGS. 11A-11H are simplified cross-sectional views illustrating various manufacturing steps of an example microelectronic assembly according to some embodiments of the present disclosure.
FIG. 12 is a cross-sectional view of a device package that may include one or more microelectronic assemblies in accordance with any of the embodiments disclosed herein.
FIG. 13 is a cross-sectional side view of a device assembly that may include one or more microelectronic assemblies in accordance with any of the embodiments disclosed herein.
FIG. 14 is a block diagram of an example computing device that may include one or more microelectronic assemblies in accordance with any of the embodiments disclosed herein.

### DETAILED DESCRIPTION

For purposes of illustrating IC packages described herein, it is important to understand phenomena that may come into play during assembly and packaging of ICs. The following foundational information may be viewed as a basis from which the present disclosure may be properly explained. Such information is offered for purposes of explanation only and, accordingly, should not be construed in a way that limits the broad scope of the present disclosure and its potential applications.

Die partitioning, in which multiple smaller dies are coupled together by high-density interconnects, may achieve smaller form factors and higher yields than utilizing a single, monolithic die. However, coupling dies together at the fine pitch needed to achieve desired interconnect density has been limited by conventional approaches. One approach to achieving a finer pitch includes incorporating a thin glass core into a package substrate.

The structures and assemblies disclosed herein may include a glass core, also referred to herein as a "glass layer," having a protective material on a top surface and a bottom surface. A glass core as compared to a conventional epoxy core offers several advantages including higher through-glass via (TGV) density, lower signal losses, and lower total thickness variation (TTV), among others. However, the manufacture of glass core substrates, especially using existing high volume manufacturing equipment, may be challenging due to the brittleness of glass, which may form cracks that may propagate and cause malfunctions in electrical circuitry. A glass core may be reinforced during manufacturing by layering the glass core with a dielectric material (e.g., forming a protective material that supports the glass core on a top surface and a bottom surface). An IC package, with a reinforced glass core, may be less susceptible to damage resulting from manufacturing operations, including singulating (e.g., by sawing) into individual units and metallization region formation. A metallization region may include a dielectric layer with conductive pathways therein formed on a surface of the glass core (e.g., on a top surface, on a bottom surface, or on top and bottom surfaces). A dielectric layer including conductive pathways also may be referred to herein as a "redistribution layer (RDL)" or a "substrate." TGVs and other conductive pathways through the glass core may provide for front-to-back connections between two different metallization regions. The substrates may provide routing for design flexibility, and the encapsulated glass core may provide dimensional stability, allowing the structures and assemblies disclosed herein to exhibit little to no warpage.

Accordingly, disclosed herein are microelectronic assemblies including reinforced glass layers, as well as related devices and methods. In some embodiments, a microelectronic assembly may include a glass layer having a first surface and an opposing second surface, the glass layer including a through-glass via (TGV); a first material on the first surface of the glass layer, the first material including a dielectric material, a mold material, or an epoxy material; a first conductive via extending through the first material, wherein the first conductive via has tapered sides and a smaller cross-section towards the first surface of the glass layer, wherein the first conductive via is electrically coupled to the TGV; a first dielectric layer on the first material, the first dielectric layer including a first conductive pathway electrically coupled to the first conductive via; a second material on the second surface of the glass layer, the second material including an organic dielectric, a mold material, or an epoxy material; a second conductive via extending through the second material, wherein the second conductive via has tapered sides and a larger cross-section towards the second surface of the glass layer, wherein the second conductive via is electrically coupled to the TGV; and a second dielectric layer on the second material, the second dielectric layer including a second conductive pathway electrically coupled to the second conductive via. A microelectronic assembly may further include a liner between the first conductive via and the first conductive pathway, wherein a material of the liner includes titanium, nickel, palladium, or gold.

In some embodiments, a microelectronic assembly may include a glass layer having a first surface and an opposing second surface; a first material on the first surface of the glass layer, the first material including a dielectric material, a mold material, or an epoxy material; a second material on the second surface of the glass layer, the second material including an organic dielectric, a mold material, or an epoxy material; a via extending through the glass layer, the first material, and the second material, the via including a conductive material; a first substrate on the first material, the first substrate including first conductive pathways with first metal layers having a first thickness, wherein an individual first conductive pathway is electrically coupled to the via; and a second substrate on the second material, the second substrate including second conductive pathways with second metal layers having a second thickness different than the first thickness, wherein an individual second conductive pathway is electrically coupled to the via. A microelectronic assembly may further include a first substrate having a first number of metal layers and the second substrate having a second number of metal layers different than the first number of metal layers.

In some embodiments, a microelectronic assembly may include a first glass layer having a first surface and an opposing second surface, the first glass layer including a first through-glass via (TGV); a first substrate on the first surface of the first glass layer, the first substrate including a first conductive pathway electrically coupled to the first TGV; a second glass layer having a first surface and an opposing second surface, the second glass layer including a second TGV; and a second substrate on the second surface of the second glass layer the second substrate including a second conductive pathway electrically coupled to the second TGV, wherein the first TGV at the second surface of the first glass layer is electrically coupled to the second TGV at the first surface of the second glass layer by an interconnect including solder.

Each of the structures, assemblies, packages, methods, devices, and systems of the present disclosure may have several innovative aspects, no single one of which is solely responsible for all the desirable attributes disclosed herein. Details of one or more implementations of the subject matter described in this specification are stated in the description below and the accompanying drawings.

In the following detailed description, various aspects of the illustrative implementations may be described using terms commonly employed by those skilled in the art to convey the substance of their work to others skilled in the art.

The terms "circuit" and "circuitry" mean one or more passive and/or active electrical and/or electronic components that are arranged to cooperate with one another to provide a desired function. The terms also refer to analog circuitry, digital circuitry, hard wired circuitry, programmable circuitry, microcontroller circuitry and/or any other type of physical hardware electrical and/or electronic component.

The term "integrated circuit" means a circuit that is integrated into a monolithic semiconductor or analogous material.

In some embodiments, the IC dies disclosed herein may comprise substantially monocrystalline semiconductors, such as silicon or germanium, as a base material on which integrated circuits are fabricated with traditional semiconductor processing methods. The semiconductor base material may include, for example, N-type or P-type materials. Dies may include, for example, a crystalline base material formed using a bulk silicon (or other bulk semiconductor material) or a semiconductor-on-insulator (SOI, e.g., a silicon-on-insulator) structure. In some other embodiments, the base material of one or more of the IC dies may comprise alternate materials, which may or may not be combined with silicon, that include but are not limited to germanium, indium antimonide, lead telluride, indium arsenide, indium phosphide, gallium arsenide, indium gallium arsenide, gallium antimonide, or other combinations of group III-N, group III-V, group II-VI, or group IV materials. In yet other embodiments, the base material may comprise compound semiconductors, for example, with a first sub-lattice of at least one element from group III of the periodic table (e.g., Al, Ga, In), and a second sub-lattice of at least one element of group V of the periodic table (e.g., P, As, Sb). In yet other embodiments, the base material may comprise an intrinsic IV or III-V semiconductor material or alloy, not intentionally doped with any electrically active impurity; in alternate embodiments, nominal impurity dopant levels may be present. In still other embodiments, dies may comprise a non-crystalline material, such as polymers; for example, the base material may comprise silica-filled epoxy. In other embodiments, the base material may comprise high mobility oxide semiconductor material, such as tin oxide, antimony oxide, indium oxide, indium tin oxide, titanium oxide, zinc oxide, indium zinc oxide, indium gallium zinc oxide (IGZO), gallium oxide, titanium oxynitride, ruthenium oxide, or tungsten oxide. In general, the base material may include one or more of tin oxide, cobalt oxide, copper oxide, antimony oxide, ruthenium oxide, tungsten oxide, zinc oxide, gallium oxide, titanium oxide, indium oxide, titanium oxynitride, indium tin oxide, indium zinc oxide, nickel oxide, niobium oxide, copper peroxide, IGZO, indium telluride, molybdenite, molybdenum diselenide, tungsten diselenide, tungsten disulfide, N- or P-type amorphous or polycrystalline silicon, germanium, indium gallium arsenide, silicon germanium, gallium nitride, aluminum gallium nitride, indium phosphide, and black phosphorus, each of which may possibly be doped with one or more of gallium, indium, aluminum, fluorine, boron, phosphorus, arsenic, nitrogen, tantalum, tungsten, and magnesium, etc. Although a few examples of the material for dies are described here, any material or structure that may serve as a foundation (e.g., base material) upon which IC circuits and structures as described herein may be built falls within the spirit and scope of the present disclosure.

Unless described otherwise, IC dies described herein include one or more IC structures (or, simply, "ICs") implementing (i.e., configured to perform) certain functionality. In one such example, the term "memory die" may be used to describe a die that includes one or more ICs implementing memory circuitry (e.g., ICs implementing one or more of memory devices, memory arrays, control logic configured to control the memory devices and arrays, etc.). In another such example, the term "compute die" may be used to describe a die that includes one or more ICs implementing logic/compute circuitry (e.g., ICs implementing one or more of input/output (I/O) functions, arithmetic operations, pipelining of data, etc.).

In another example, the terms "package" and "IC package" are synonymous, as are the terms "die" and "IC die." Note that the terms "chip," "chiplet," "die," and "IC die" are used interchangeably herein.

The term "insulating" means "electrically insulating," the term "conducting" means "electrically conducting," unless otherwise specified. With reference to optical signals and/or devices, components and elements that operate on or using optical signals, the term "conducting" can also mean "optically conducting."

The terms "oxide," "carbide," "nitride," etc. refer to compounds containing, respectively, oxygen, carbon, nitrogen, etc.

The term "high-k dielectric" refers to a material having a higher dielectric constant than silicon oxide, while the term "low-k dielectric" refers to a material having a lower dielectric constant than silicon oxide.

The term "insulating material" refers to solid materials (and/or liquid materials that solidify after processing as described herein) that are substantially electrically nonconducting. They may include, as examples and not as limitations, organic polymers and plastics, and inorganic materials such as ionic crystals, porcelain, glass, silicon and alumina or a combination thereof. They may include dielectric materials, high polarizability materials, and/or piezoelectric materials. They may be transparent or opaque without departing from the scope of the present disclosure. Further examples of insulating materials are underfills and molds or mold-like materials used in packaging applications, including for example, materials used in organic interposers, package supports and other such components.

In various embodiments, elements associated with an IC may include, for example, transistors, diodes, power sources, resistors, capacitors, inductors, sensors, transceivers, receivers, antennas, etc. In various embodiments, elements associated with an IC may include those that are monolithically integrated within an IC, mounted on an IC, or those connected to an IC. The ICs described herein may be either analog or digital and may be used in a number of applications, such as microprocessors, optoelectronics, logic blocks, audio amplifiers, etc., depending on the components associated with the IC. The ICs described herein may be employed in a single IC die or as part of a chipset for executing one or more related functions in a computer.

In various embodiments of the present disclosure, transistors described herein may be field-effect transistors (FETs), e.g., metal oxide semiconductor (MOS) FETs (MOSFETs). In general, a FET is a three-terminal device that includes source, drain, and gate terminals and uses electric field to control current flowing through the device. A FET typically includes a channel material, a source region and a drain regions provided in and/or over the channel material, and a gate stack that includes a gate electrode material, alternatively referred to as a "work function" material, provided over a portion of the channel material (the "channel portion") between the source and the drain regions, and optionally, also includes a gate dielectric material between the gate electrode material and the channel material.

In a general sense, an "interconnect" refers to any element that provides a physical connection between two other elements. For example, an electrical interconnect provides electrical connectivity between two electrical components, facilitating communication of electrical signals between them; an optical interconnect provides optical connectivity between two optical components, facilitating communication of optical signals between them. As used herein, both electrical interconnects and optical interconnects are comprised in the term "interconnect." The nature of the interconnect being described is to be understood herein with reference to the signal medium associated therewith. Thus, when used with reference to an electronic device, such as an IC that operates using electrical signals, the term "interconnect" describes any element formed of an electrically conductive material for providing electrical connectivity to one or more elements associated with the IC or/and between various such elements. In such cases, the term "interconnect" may refer to both conductive traces (also sometimes referred to as "lines," "wires," "metal lines" or "trenches") and conductive vias (also sometimes referred to as "vias" or "metal vias"). Sometimes, electrically conductive traces and vias may be referred to as "conductive traces" and "conductive vias", respectively, to highlight the fact that these elements include electrically conductive materials such as metals. Likewise, when used with reference to a device that operates on optical signals as well, such as a photonic IC (PIC), "interconnect" may also describe any element formed of a material that is optically conductive for providing optical connectivity to one or more elements associated with the PCI. In such cases, the term "interconnect" may refer to optical waveguides (e.g., structures that guide and confine light waves), including optical fiber, optical splitters, optical combiners, optical couplers, and optical vias.

The term "conductive trace" may be used to describe an electrically conductive element isolated by an insulating material. Within IC dies, such insulating material comprises interlayer low-k dielectric that is provided within the IC die. Within package substrates, and printed circuit boards (PCBs) such insulating material comprises organic materials such as Ajinomoto Buildup Film (ABF), polyimides, or epoxy resin. Such conductive lines are typically arranged in several levels, or several layers, of metallization stacks.

The term "conductive via" may be used to describe an electrically conductive element that interconnects two or more conductive lines of different levels of a metallization stack. To that end, a via may be provided substantially perpendicularly to the plane of an IC die/chip or a support structure over which an IC structure is provided and may interconnect two conductive lines in adjacent levels or two conductive lines in non-adjacent levels.

The term "package substrate" may be used to describe any substrate material that facilitates the packaging together of any collection of semiconductor dies and/or other electrical components such as passive electrical components. As used herein, a package substrate may be formed of any material including, but not limited to, insulating materials such as resin impregnated glass fibers (e.g., PCB or Printed Wiring Boards (PWB)), glass, ceramic, silicon, silicon carbide, etc. In addition, as used herein, a package substrate may refer to a substrate that includes buildup layers (e.g., ABF layers).

The term "metallization stack" may be used to refer to a stack of one or more interconnects for providing connectivity to different circuit components of an IC die/chip and/or a package substrate.

The terms "substantially," "close," "approximately," "near," and "about," generally refer to being within +/- 20% of a target value (e.g., within +/- 5% or 10% of a target value) based on the context of a particular value as described herein or as known in the art.

Terms indicating orientation of various elements, e.g., "coplanar," "perpendicular," "orthogonal," "parallel," or any other angle between the elements, generally refer to being within +/-5%-20% of a target value based on the context of a particular value as described herein or as known in the art.

The term "connected" means a direct connection (which may be one or more of a mechanical, electrical, and/or thermal connection) between the things that are connected, without any intermediary devices, while the term "coupled" means either a direct connection between the things that are connected, or an indirect connection through one or more passive or active intermediary devices.

The description uses the phrases "in an embodiment" or "in embodiments," which may each refer to one or more of the same or different embodiments.

Furthermore, the terms "comprising," "including," "having," and the like, as used with respect to embodiments of the present disclosure, are synonymous.

The disclosure may use perspective-based descriptions such as "above," "below," "top," "bottom," and "side"; such descriptions are used to facilitate the discussion and are not intended to restrict the application of disclosed embodiments.

The terms "over," "under," "between," and "on" as used herein refer to a relative position of one material layer or component with respect to other layers or components. For example, one layer disposed over or under another layer may be directly in contact with the other layer or may have one or more intervening layers. Moreover, one layer disposed between two layers may be directly in contact with one or both of the two layers or may have one or more intervening layers. In contrast, a first layer described to be "on" a second layer refers to a layer that is in direct contact with that second layer. Similarly, unless explicitly stated otherwise, one feature disposed between two features may be in direct contact with the adjacent features or may have one or more intervening layers.

The term "dispose" as used herein refers to position, location, placement, and/or arrangement rather than to any particular method of formation.

The term "between," when used with reference to measurement ranges, is inclusive of the ends of the measurement ranges.

For the purposes of the present disclosure, the phrase "A and/or B" means (A), (B), or (A and B). For the purposes of the present disclosure, the phrase "A, B, and/or C" means (A), (B), (C), (A and B), (A and C), (B and C), or (A, B, and C). When used herein, the notation "A/B/C" means (A), (B), and/or (C).

Although certain elements may be referred to in the singular herein, such elements may include multiple sub-elements. For example," an electrically conductive material" may include one or more electrically conductive materials. In another example, "a dielectric material" may include one or more dielectric materials.

Unless otherwise specified, the use of the ordinal adjectives "first," "second," and "third," etc., to describe a common object, merely indicate that different instances of like objects are being referred to, and are not intended to imply that the objects so described must be in a given sequence, either temporally, spatially, in ranking or in any other manner.

In the following detailed description, reference is made to the accompanying drawings that form a part hereof, and in which is shown, by way of illustration, embodiments that may be practiced. It is to be understood that other embodiments may be utilized, and structural or logical changes may be made without departing from the scope of the present disclosure. Therefore, the following detailed description is not to be taken in a limiting sense.

The accompanying drawings are not necessarily drawn to scale.

In the drawings, same reference numerals refer to the same or analogous elements/materials shown so that, unless stated otherwise, explanations of an element/material with a given reference numeral provided in context of one of the drawings are applicable to other drawings where element/materials with the same reference numerals may be illustrated.

Furthermore, in the drawings, some schematic illustrations of example structures of various devices and assemblies described herein may be shown with precise right angles and straight lines, but it is to be understood that such schematic illustrations may not reflect real-life process limitations which may cause the features to not look so "ideal" when any of the structures described herein are examined using, e.g., images of suitable characterization tools such as scanning electron microscopy (SEM) images, transmission electron microscope (TEM) images, or non-contact profilometer. In such images of real structures, possible processing and/or surface defects could also be visible, e.g., surface roughness, curvature or profile deviation, pit or scratches, not-perfectly straight edges of materials, tapered vias or other openings, inadvertent rounding of corners or variations in thicknesses of different material layers, occasional screw, edge, or combination dislocations within the crystalline region(s), and/or occasional dislocation defects of single atoms or clusters of atoms. There may be other defects not listed here but that are common within the field of device fabrication and/or packaging.

Note that in the figures, various components (e.g., interconnects) are shown as aligned (e.g., at respective interfaces) merely for ease of illustration; in actuality, some or all of them may be misaligned. In addition, there may be other components, such as bond-pads, landing pads, metallization, etc. present in the assembly that are not shown in the figures to prevent cluttering. Further, the figures are intended to show relative arrangements of the components within their assemblies, and, in general, such assemblies may include other components that are not illustrated (e.g., various interfacial layers or various other components related to optical functionality, electrical connectivity, or thermal mitigation). For example, in some further embodiments, the assembly as shown in the figures may include more dies along with other electrical components. Additionally, although some components of the assemblies are illustrated in the figures as being planar rectangles or formed of rectangular solids, this is simply for ease of illustration, and embodiments of these assemblies may be curved, rounded, or otherwise irregularly shaped as dictated by and sometimes inevitable due to the manufacturing processes used to fabricate various components.

In the drawings, a particular number and arrangement of structures and components are presented for illustrative purposes and any desired number or arrangement of such structures and components may be present in various embodiments.

Further, unless otherwise specified, the structures shown in the figures may take any suitable form or shape according to material properties, fabrication processes, and operating conditions.

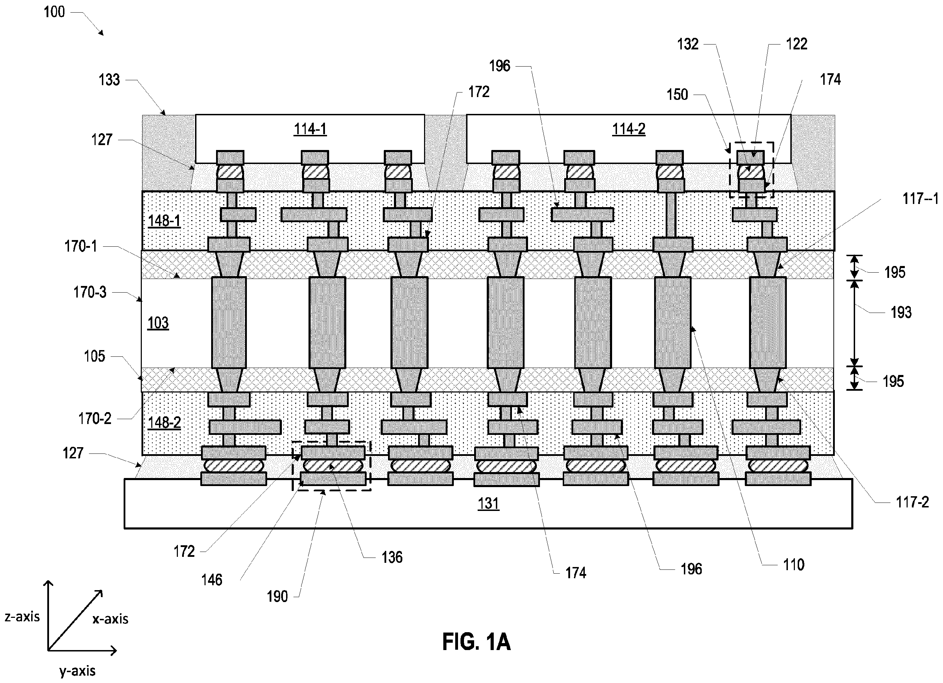

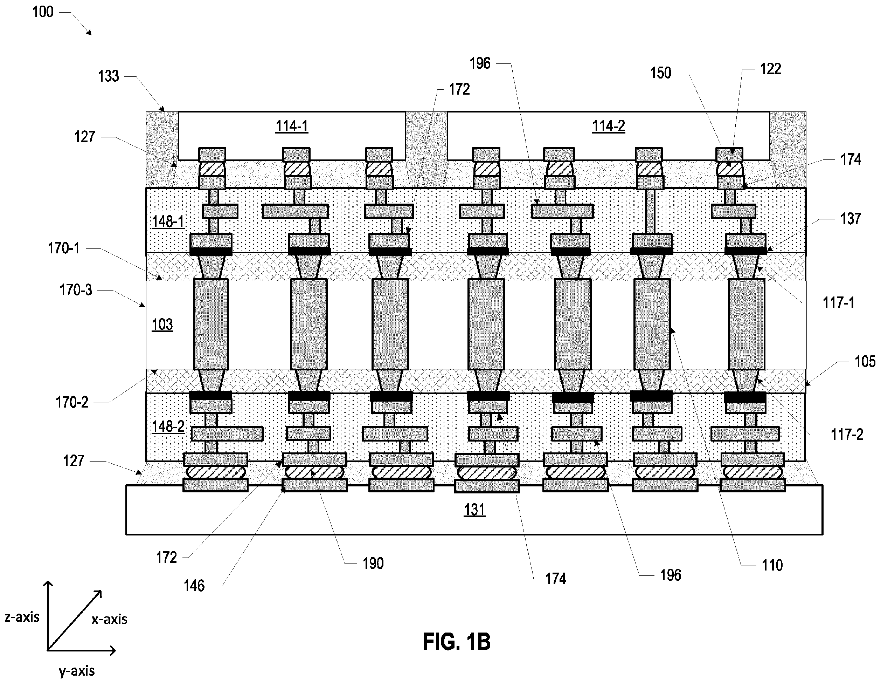

For convenience, if a collection of drawings designated with different letters are present (e.g., FIGS. 1A and 1B), such a collection may be referred to herein without the letters (e.g., as "FIG. 1"). Similarly, if a collection of reference numerals designated with different numbers are present (e.g., 148-1, 148-2), such a collection may be referred to herein without the numbers (e.g., as "148").

Various operations may be described as multiple discrete actions or operations in turn in a manner that is most helpful in understanding the claimed subject matter. However, the order of description should not be construed as to imply that these operations are necessarily order dependent. In particular, these operations may not be performed in the order of presentation. Operations described may be performed in a different order from the described embodiment. Various additional operations may be performed, and/or described operations may be omitted in additional embodiments.

FIG. 1A is a schematic cross-sectional view of an example microelectronic assembly 100 according to some embodiments of the present disclosure. Microelectronic assembly 100 may include a glass layer 103 having a buffer material 105 on a top surface and a bottom surface. The buffer material 105 may protect the glass layer 103 and reduce damage resulting from compression and tensile stress. A glass layer 103 may have a first surface 170-1 (e.g., a top surface), an opposing second surface 170-2 (e.g., a bottom surface), and side surfaces 170-3 extending between the first and second surfaces. A buffer material 105 may include a dielectric material, such as an organic dielectric, a mold material, or an epoxy material, such as an epoxy material with silica fillers or an epoxy-based organic material. In some embodiments, a buffer material 105 may have a thickness 195 (e.g., a z-height from a first surface 170-1 or a second surface 170-2 of the glass layer 103) between 5 microns and 100 microns. A width 197 of the buffer material 105 may depend on a singulation process. In some embodiments, a buffer material 105 may have a width 197 (e.g., y-dimension) between 10 microns and 500 microns.

A glass layer 103 may include any suitable type of glass known in the art, including but not limited to any type of bulk amorphous or polycrystalline transparent, opaque, or semi-transparent glass, such as borosilicate glass, soda lime glass, quartz, a fused-silica glass, an alkali glass, a ceramic glass, or other solid volume of glass material. As used herein, a glass layer 103 does not include glass fiber reinforced polymers. In some embodiments, the glass layer 103 may include a photoimageable glass, a photoglass, or other borosilicate-based glasses with oxide additions. In some embodiments, a thickness 193 of a glass layer 103 may be between 50 microns and 1500 microns (i.e., between 100 microns and 1 millimeter).

The microelectronic assembly 100 may further include one or more through-vias. As used herein, a through-via includes a TGV 110 that extends through the glass layer 103 and that electrically couples with conductive vias 117-1, 117-2 through the buffer material 105 on the first and second surfaces 170-1, 170-2 of the glass layer 103, respectively. The conductive vias 117-1, 117-2 may have a same orientation in the microelectronic assembly 100, where the conductive vias 117-1, 117-2 have tapered sides (e.g., a V-shape), where a top portion (e.g., the portion towards a first substrate 148-1) has a larger cross-section (e.g., xy-dimension) than a bottom portion (e.g., the portion towards a second substrate 148-2). The one or more through-vias may enable power, ground and signal connectivity to components located on either side of the glass layer 103, for example, between dies 114-1, 114-2 and a circuit board 131. TGVs 110 may have any suitable size and shape. TGVs 110 is shown as having straight, parallel edges; however, in various embodiments, the edges may be tapered and/or have other irregularities depending on the processing conditions for generating TGVs 110. TGVs 110 and conductive vias 117 may be formed using any suitable process, including, for example, laser drilling via openings through the glass layer 103 or the buffer material 105, and depositing a conductive material in the openings. In some embodiments, TGVs 110 may be formed using a laser ablation and chemical etching process. TGVs 110 and conductive vias 117 may be formed of any suitable conductive material, such as copper, silver, nickel, gold, aluminum, or other metals or alloys, for example. In some embodiments, a diameter of the TGVs 110 may be between 25 microns and 200 microns (e.g., between 50 microns and 100 microns). In some embodiments, a pitch of the TGVs 110 may be between 1.5 times the diameter (e.g., between 37.5 microns and 300 microns).

The microelectronic assembly 100 may further include a first substrate 148-1 at the first surface 170-1 of the glass layer 103 and a second substrate 148-2 at the second surface 170-2 of the glass layer 103. The first and second substrates 148-1, 148-2 may include conductive pathways 196 (e.g., including conductive traces and/or conductive vias, as shown) through a dielectric material. The substrates 148 may include a set of first conductive contacts 172 on the bottom surface of the substrate 148 and a set of second conductive contacts 174 on the top surface of the substrate 148, where the conductive pathways 196 electrically couple individual ones of the first and second conductive contacts 172, 174. The first and second substrates 148-1, 148-2 may be manufactured using any suitable technique, such as a PCB technique or a redistribution layer technique. In some embodiments, a dielectric material of the substrate 148 may include bismaleimide triazine (BT) resin, polyimide materials, epoxy materials (e.g., glass reinforced epoxy matrix materials, epoxy build-up films, or the like), mold materials, oxide-based materials (e.g., silicon dioxide or spin on oxide), or low-k and ultra low-k dielectric (e.g., carbon-doped dielectrics, fluorine-doped dielectrics, porous dielectrics, and organic polymeric dielectrics). In some embodiments, the buffer material 105 and the first and second substrates 148-1, 148-2 may include a same material, for example, an organic dielectric material. The one or more through-vias may electrically couple the first and second substrates 148-1, 148-2 (e.g., through the TGVs 110 and the conductive vias 117 in the buffer material 105). As used herein, the glass layer 103 with the first substrate 148-1 and/or the second substrate 148-2 may be referred to as a package substrate.

The microelectronic assembly 100 may further include die 114-1 and die 114-2 electrically coupled to a top surface of the first substrate 148-1 by interconnects 150. In particular, conductive contacts 122 on a bottom surface of die 114-1, 114-2 may be electrically and mechanically coupled to conductive contacts 174 at a top surface of the first substrate 148-1 by interconnects 150.

Interconnects 150 may enable electrical coupling between die 114-1 and die 114-2 through conductive pathways 196 in substrate 148-1. Interconnects 150 disclosed herein may take any suitable form, including solder balls for a ball grid array arrangement, pins in a pin grid array arrangement or lands in a land grid array arrangement. In some embodiments, a set of interconnects 150 may include solder 132 (e.g., solder bumps or balls that are subject to a thermal reflow to form the interconnects 150). Interconnects 150 that include solder may include any appropriate solder material, such as lead/tin, tin/bismuth, eutectic tin/silver, ternary tin/silver/copper, eutectic tin/copper, tin/nickel/copper, tin/bismuth/copper, tin/indium/copper, tin/zinc/indium/bismuth, or other alloys. In some embodiments, a set of interconnects 150 may include an anisotropic conductive material, such as an anisotropic conductive film or an anisotropic conductive paste. An anisotropic conductive material may include conductive materials dispersed in a non-conductive material. In some embodiments, an anisotropic conductive material may include microscopic conductive particles embedded in a binder or a thermoset adhesive film (e.g., a thermoset biphenyl-type epoxy resin, or an acrylic-based material). In some embodiments, the conductive particles may include a polymer and/or one or more metals (e.g., nickel or gold). For example, the conductive particles may include nickel-coated gold or silver-coated copper that is in turn coated with a polymer. In another example, the conductive particles may include nickel. When an anisotropic conductive material is uncompressed, there may be no conductive pathway from one side of the material to the other. However, when the anisotropic conductive material is adequately compressed (e.g., by conductive contacts on either side of the anisotropic conductive material), the conductive materials near the region of compression may contact each other so as to form a conductive pathway from one side of the film to the other in the region of compression. In some embodiments, interconnects 150 disclosed herein may have a pitch between about 18 microns and 75 microns.

The die 114 disclosed herein may include an insulating material (e.g., a dielectric material formed in multiple layers, as known in the art) and multiple conductive pathways formed through the insulating material. In some embodiments, the insulating material of a die 114 may include a dielectric material, such as silicon dioxide, silicon nitride, oxynitride, polyimide materials, glass reinforced epoxy matrix materials, or a low-k or ultra low-k dielectric (e.g., carbon-doped dielectrics, fluorine-doped dielectrics, porous dielectrics, organic polymeric dielectrics, photo-imageable dielectrics, and/or benzocyclobutene-based polymers). In some embodiments, the insulating material of a die 114 may include a semiconductor material, such as silicon, germanium, or a III-V material (e.g., gallium nitride), and one or more additional materials. For example, an insulating material may include silicon oxide or silicon nitride. The conductive pathways in a die 114 may include conductive traces and/or conductive vias, and may connect any of the conductive contacts in the die 114 in any suitable manner (e.g., connecting multiple conductive contacts on a same surface or on different surfaces of the die 114). The conductive pathways in the dies 114 may be bordered by liner materials, such as adhesion liners and/or barrier liners, as suitable. In some embodiments, the die 114 is a wafer. In some embodiments, the die 114 is a monolithic silicon, a fan-out or fan-in package die, or a die stack (e.g., wafer stacked, die stacked, or multi-layer die stacked). In various embodiments, die 114 may include, or be a part of, one or more of a central processing unit (CPU), a memory device (e.g., a high-bandwidth memory device), a logic circuit, input/output circuitry, a transceiver such as a field programmable gate array transceiver, a gate array logic such as a field programmable gate array logic, of a power delivery circuitry, a III-V or a III-N device such as a III-N or III-N amplifier (e.g., GaN amplifier), Peripheral Component Interconnect Express (PCle) circuitry, Double Data Rate (DDR) transfer circuitry, or other electronic components known in the art. In some embodiments, die 114-1 and die 114-2 may comprise different functionalities. As used herein, the term "functionality" with reference to a die refers to one or more functions (e.g., capability, task, operation, action, instruction execution, etc.) that the die in question can perform. For example, die 114-1 may be a CPU and die 114-2 may be a Graphics Processing Unit (GPU) or memory. In other embodiments, die 114-1 and die 114-2 may comprise the same or similar functionalities. For example, die 114-1 and die 114-2 may each comprise memory.

The microelectronic assembly 100 of FIG. 1A may also include an insulating material 133 that encapsulates the die 114 (e.g., on and around die 114 and interconnects 150). The insulating material 133 may extend from a top surface of the first substrate 148-1 to a top surface of the die 114. In some embodiments, the insulating material 133 may be a mold material, such as an organic polymer with inorganic silicon oxide or aluminum oxide particles, a resin material, or an epoxy material. In some embodiments (not shown) other components, such as heat sinks may be coupled to microelectronic assembly 100 based on particular needs.

The microelectronic assembly 100 of FIG. 1A may also include an underfill material 127. In some embodiments, the underfill material 127 may extend between die 114-1, 114-2 and the first substrate 148-1 around the associated interconnects 150. The underfill material 127 may be an insulating material, such as an appropriate epoxy material. In some embodiments, the underfill material 127 may include a capillary underfill, non-conductive film (NCF), or molded underfill. In some embodiments, the underfill material 127 may include an epoxy flux that assists with soldering die 114-1, 114-2 to the first substrate 148-1 when forming the interconnects 150, and then polymerizes and encapsulates the interconnects 150. The underfill process may include dispensing underfill material in liquid form, allowing the material to flow and fill the interstitial gaps around interconnects 150, and subjecting the assembly to a curing process, such as baking, to solidify the material. In some embodiments, an underfill material 127 may be omitted. Although FIG. 1A shows two separate underfill 127 portions under die 114-1 and die 114-2, the underfill 127 may be a single underfill 127 under die 114-1 and die 114-2. The underfill material 127 may be selected to have a coefficient of thermal expansion (CTE) that may mitigate or minimize the stress between die 114 and the second substrate 148-2 arising from uneven thermal expansion in the microelectronic assembly 100. In some embodiments, the CTE of the underfill material 127 may have a value that is intermediate to the CTE of the first substrate 148-1 (e.g., the CTE of the dielectric material of the substrate 148) and a CTE of the insulating material of die 114.

The microelectronic assembly 100 of FIG. 1A may also include a circuit board 131. In particular, conductive contacts 172 on a bottom surface of the first substrate 148-1 may be electrically coupled to conductive contacts 146 on a top surface of circuit board 131 by interconnects 190. Interconnects 190 disclosed herein may take any suitable form, including any of the forms described above with reference to interconnects 150. As shown in FIG. 1A, in some embodiments, a set of interconnects 190 may include solder 136 (e.g., solder bumps or balls that are subject to a thermal reflow to form the interconnects 190). In some embodiments, the interconnects 190 disclosed herein may have a pitch between about 50 microns and 300 microns. In some embodiments, an underfill material 127 may extend between the second substrate 148-2 and the circuit board 131 around the associated interconnects 190. The circuit board 131 may be a motherboard, for example, and may have other components attached to it. The circuit board may include conductive pathways and other conductive contacts for routing power, ground, and signals through the circuit board, as known in the art. In some embodiments, the interconnects 190 may not couple to a circuit board 131, but may instead couple to another IC package, an interposer, or any other suitable component.

In some embodiments, one or more levels of solder resist (e.g., epoxy liquid, liquid photoimageable polymers, dry film photoimageable polymers, acrylics, solvents) may be provided in an IC package described herein and may not be labeled or shown to avoid cluttering the drawings. Solder resist may be a liquid or dry film material including photoimageable polymers. In some embodiments, solder resist may be non-photoimageable.

FIG. 1B is a schematic cross-sectional view of another example microelectronic assembly according to some embodiments of the present disclosure. The configuration of the embodiment shown in the figure is like that of FIG. 1A, except for differences as described further. The configuration of microelectronic assembly 100 as described herein further includes a liner 137 between the conductive vias 117-1, 117-2 and the conductive contacts 172, 174, respectively. The liner 137 may include any suitable material, such as titanium, nickel, palladium, or gold, and the conductive contacts 172, 174 may include a different material, such as copper. A liner 137 may have any suitable dimensions, for example, in some embodiments, a liner 137 may have a thickness (e.g., z-height) between 50 nanometers and 2 microns. During manufacturing, a liner 137 may function as an etch stop for selective metal etching.

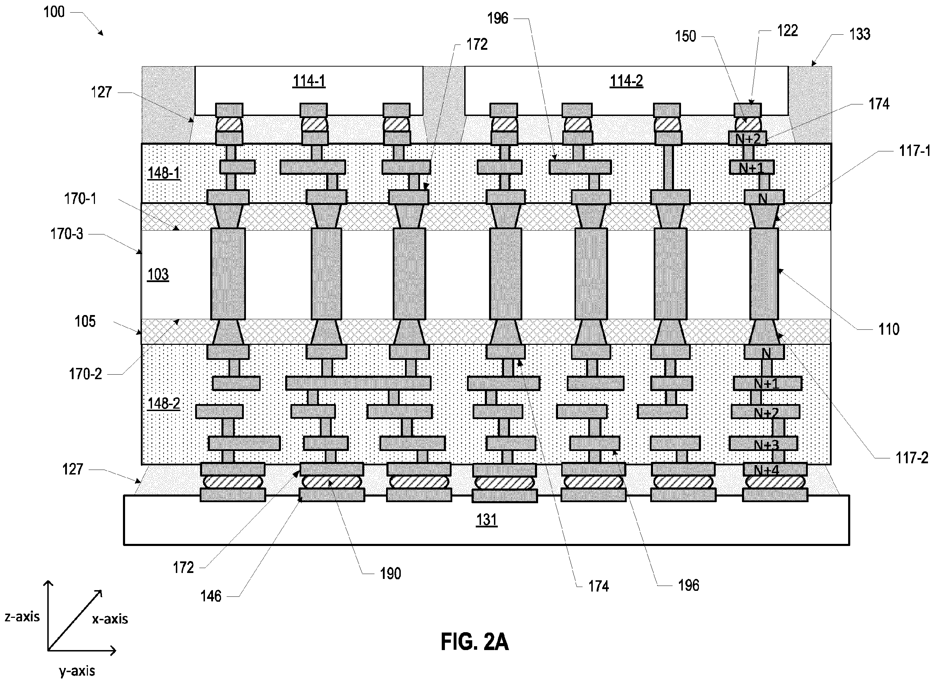

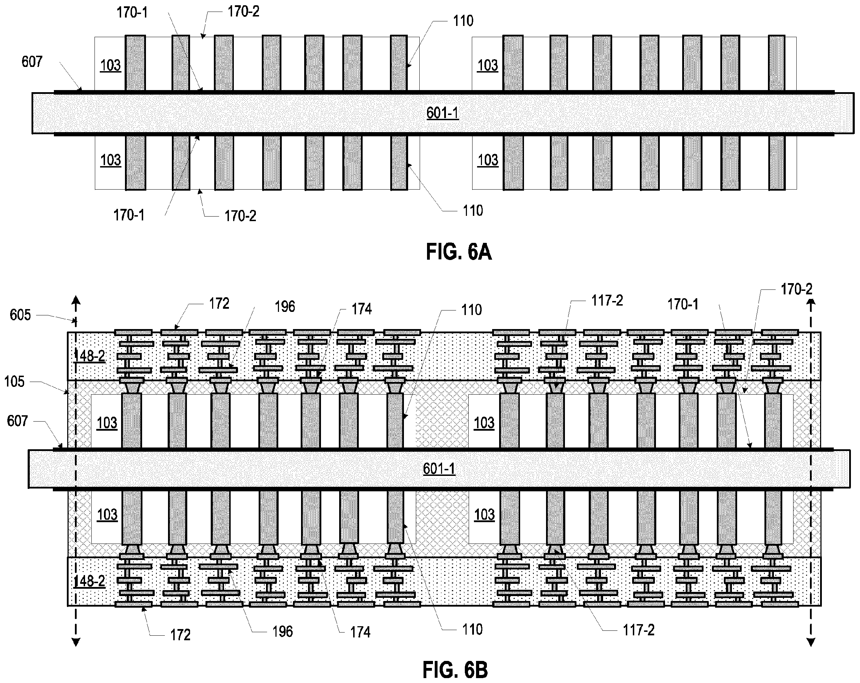

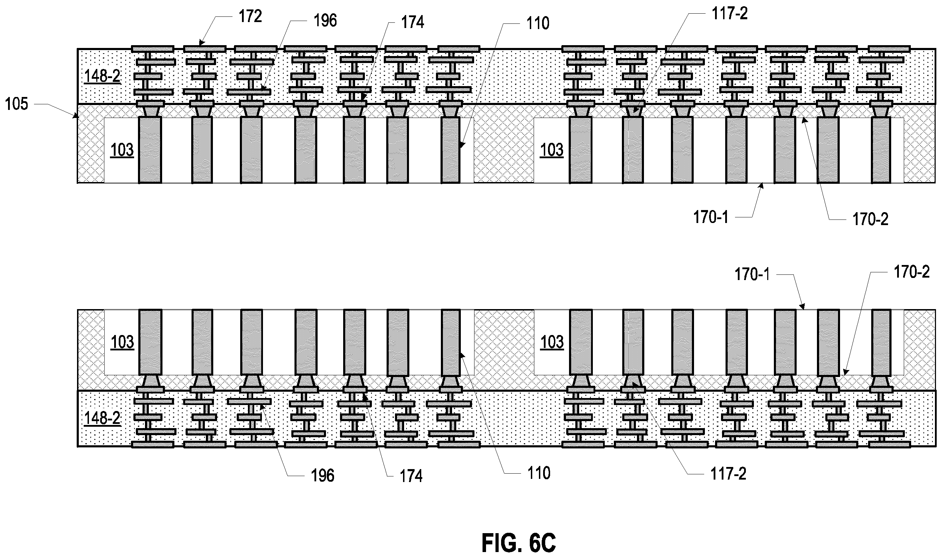

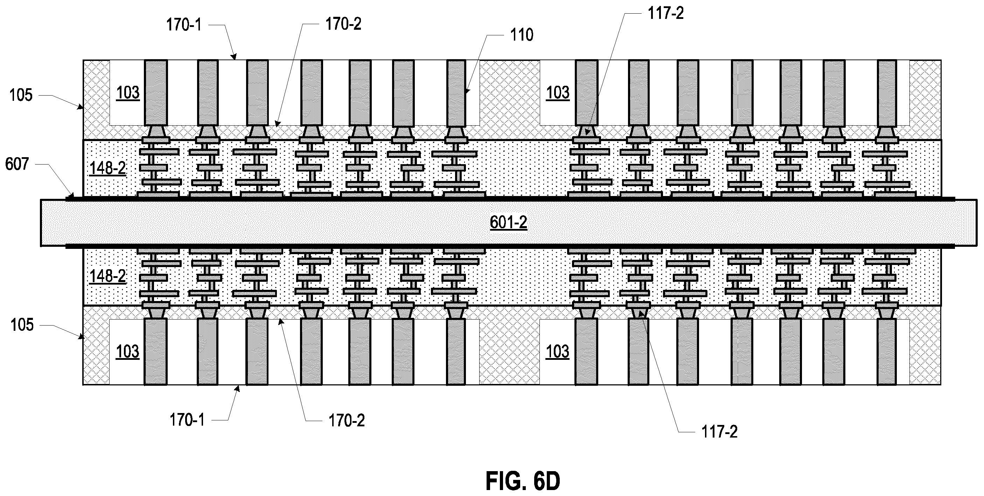

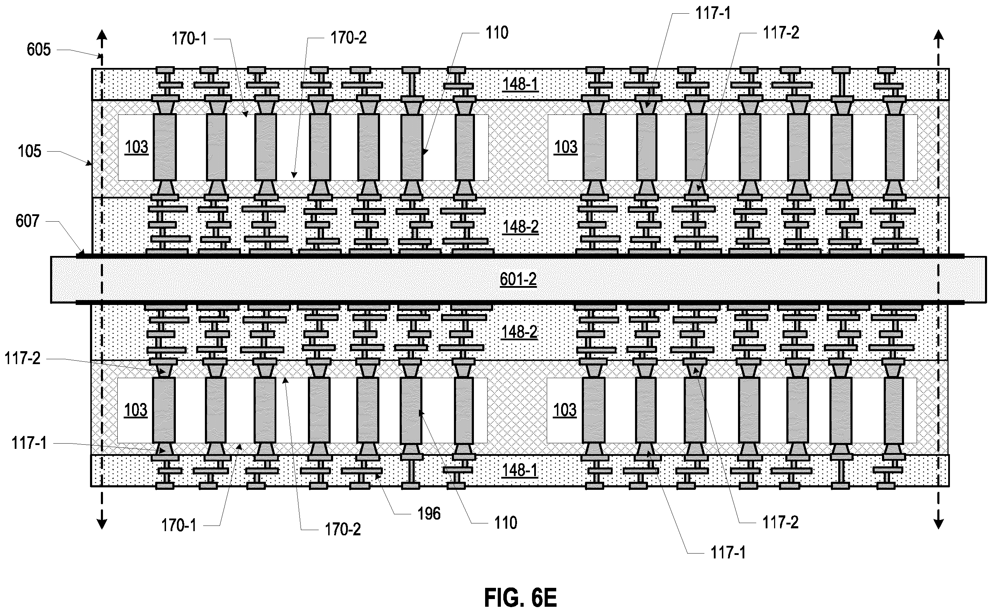

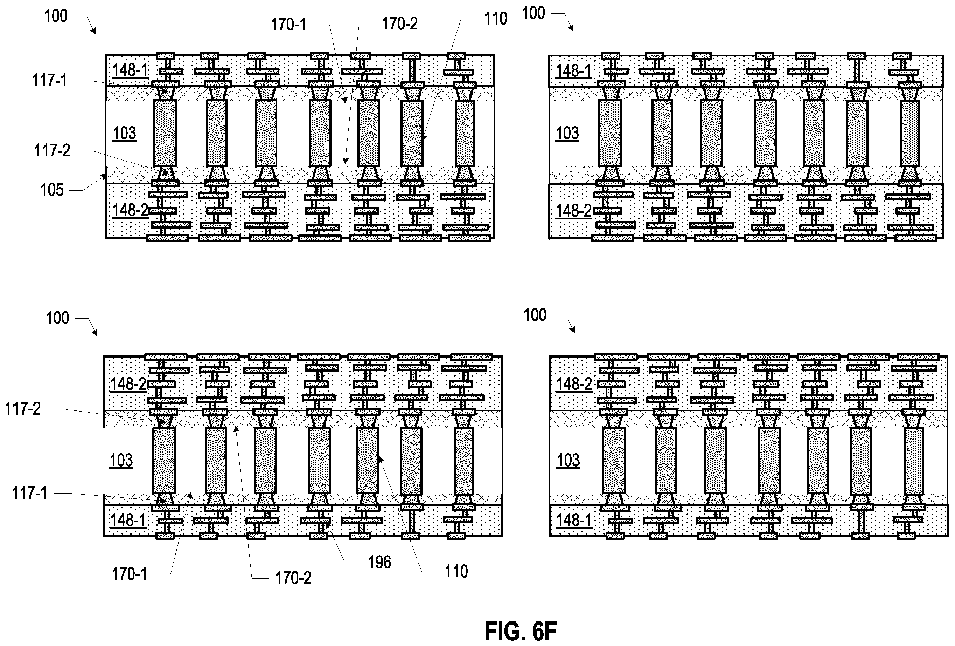

FIG. 2A is a schematic cross-sectional view of another example microelectronic assembly according to some embodiments of the present disclosure. The configuration of the embodiment shown in the figure is like that of FIG. 1A, except for differences as described further. The configuration of the microelectronic assembly 100 described herein includes conductive vias 117-1, 117-2 having a different orientation, where the conductive vias 117-1 are mirror images of conductive vias 117-2 (e.g., conductive vias 117-1 have a larger diameter (e.g., xy-dimension) towards the first substrate 148-1 and the conductive vias 117-2 have a larger diameter towards the second substrate 148-2), and the microelectronic assembly 100 is asymmetrical in that the first substrate 148-1 has a different number of metal layers as compared to the second substrate 148-2. For example, as shown, the first substrate 148-1 has three (3) metal layers (e.g., N, N+1, N+2) and the second substrate 148-2 has five (5) metal layers (e.g., N, N+1, N+2, N+3, N+4). The microelectronic assembly 100 of FIG. 2A may have conductive vias 117-1, 117-2 with different orientations and the first and second substrates 148-1, 148-2 with a different number of metal layers due to the manufacturing process, as described below with reference to FIG. 6. In particular, the first substrate 148-1 and the second substrate 148-2 may be assembled during different manufacturing steps. Although FIG. 2A illustrates a particular number and arrangement of metal layers in the first substrate 148-1 and the second substrate 148-2, a microelectronic assembly 100 may have any suitable number and arrangement of metal layers in the first substrate 148-1 and the second substrate 148-2.

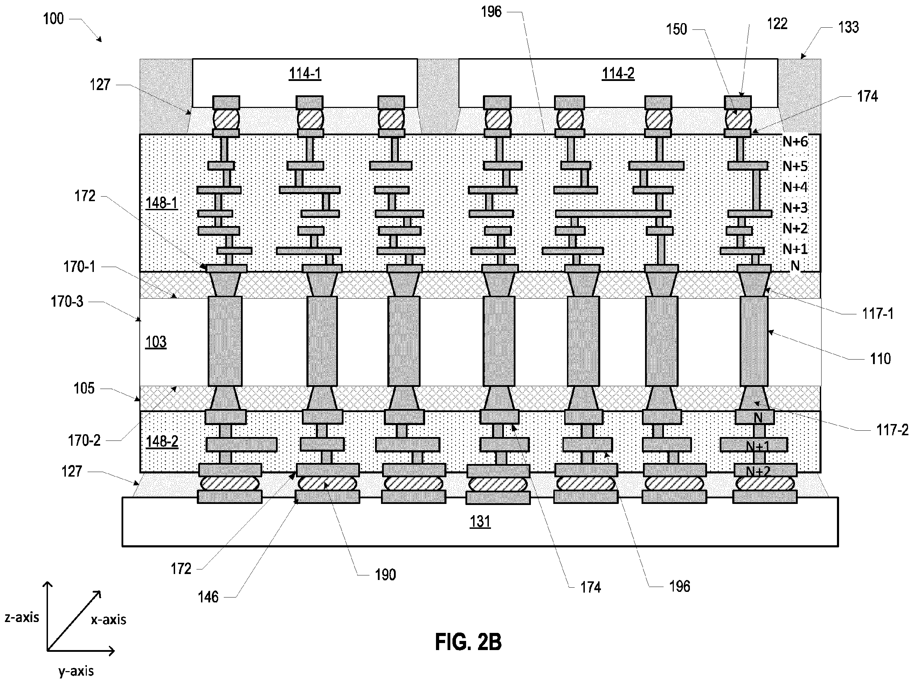

FIG. 2B is a schematic cross-sectional view of another example microelectronic assembly according to some embodiments of the present disclosure. The configuration of the embodiment shown in the figure is like that of FIG. 2A, except for differences as described further. The configuration of microelectronic assembly 100 as described herein further includes a first substrate 148-1 having metal layers with a first thickness and a second substrate 148-2 having metal layers with a second thickness different than the first thickness. In particular, the first substrate 148-1 includes seven (7) metal layers (e.g., N, N+1, N+2, N+3, N+4, N+5, N+6) having a first thickness and the second substrate 148-2 includes three (3) metal layers (e.g., N, N+1, N+2) having a second thickness that is greater than the first thickness. As shown in FIG. 2B, the second thickness is greater than the first thickness. In other embodiments, the first thickness may be greater than the second thickness. Although FIG. 2B illustrates the first substrate 148-1 and the second substrate 148-2 having a different number of metal layers, the first and second substrates 148-1, 148-2 may have a same number of metal layers.

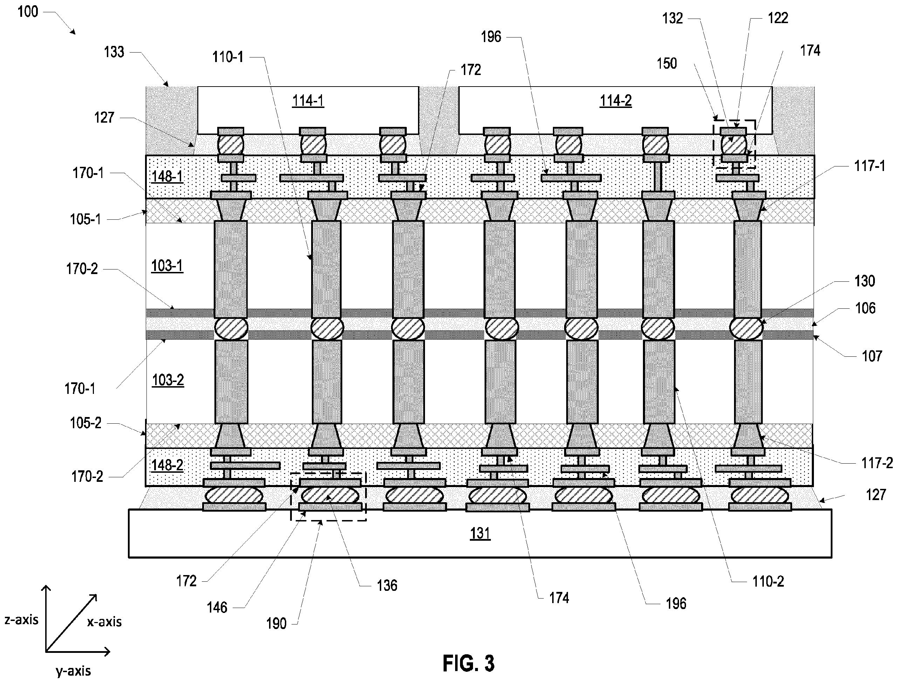

FIG. 2B is a schematic cross-sectional view of another example microelectronic assembly according to some embodiments of the present disclosure. The configuration of the embodiment shown in the figure is like that of FIG. 1A, except for differences as described further. The configuration of microelectronic assembly 100 as described herein further includes a first glass layer 103-1 and a second glass layer 103-2 electrically coupled by interconnects 130. In particular, the microelectronic assembly 100 in FIG. 3 includes a first glass layer 103-1 having first TGVs 110-1 electrically coupled to first conductive vias 117-1 through a first buffer material 105-1 at a first surface 170-1 and a first substrate 148-1 on the first buffer material 105-1, and a second glass layer 103-2 having second TGVs 110-2 electrically coupled to second conductive vias 117-2 through a second buffer material 105-2 at a second surface 170-2 and a second substrate 148-1 on the second buffer material 105-2, where the first TGVs 110-1 at the second surface 170-2 of the first glass layer 103-1 and the second TGVs 110-2 at the first surface 170-1 of the second glass layer 103-2 are electrically coupled by interconnects 130. In some embodiments, the interconnects 130 may include solder or liquid metal ink (LMI). Interconnects 130 that include solder may include any appropriate solder material, such as lead/tin, tin/bismuth, eutectic tin/silver, ternary tin/silver/copper, eutectic tin/copper, tin/nickel/copper, tin/bismuth/copper, tin/indium/copper, tin/zinc/indium/bismuth, or other alloys. The microelectronic assembly 100 may further include an insulating material 106 between the second surface 170-2 of the first glass layer 103-1 and the first surface 170-1 of the second glass layer 103-2 around the interconnects 130. The insulating material 106 may include any suitable material, such as an underfill material, a capillary underfill, an epoxy material, non-conductive film (NCF), or molded underfill. In some embodiments, the insulating material 106 may include an epoxy flux that assists with soldering the first glass layer 103-1 to the second glass layer 103-2 when forming the interconnects 130, and then polymerizes and encapsulates the interconnects 130. The underfill process may include dispensing underfill material in liquid form, allowing the material to flow and fill the interstitial gaps around interconnects 130, and subjecting the assembly to a curing process, such as baking, to solidify the material. The insulating material 106 may be selected to have a coefficient of thermal expansion (CTE) that may mitigate or minimize the stress between the first and second glass layers 103-1, 103-2. In some embodiments, the first buffer material 105-1 and the second buffer material 105-2 are a same material. In some embodiments, the first buffer material 105-1 and the second buffer material 105-2 are different materials. In some embodiments, the first buffer material 105-1, the second buffer material 105-2, and a material of the first and second substrates 148-1, 148-2 are a same material, for example, an organic dielectric material. In some embodiments, the microelectronic assembly 100 in FIG. 3 may further include an adhesive material 107 between the second surface 170-2 of the first glass layer 103-1 and the insulating material 106, and between the first surface 170-1 of the second glass layer 103-2 and the insulating material 106.

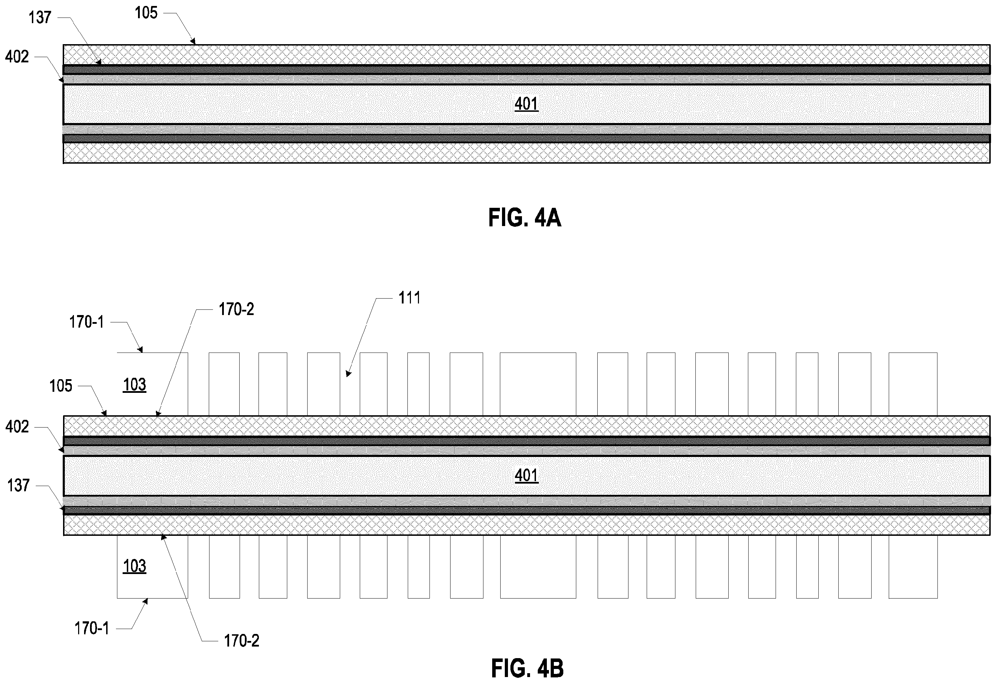

Any suitable techniques may be used to manufacture the microelectronic assemblies 100 disclosed herein. For example, FIGS. 4A-4L are side, cross-sectional views of various stages in an example process for manufacturing the microelectronic assembly 100 of FIG. 1A, in accordance with various embodiments. Although the operations discussed below with reference to FIGS. 4A-4L (and others of the accompanying drawings representing manufacturing processes) are illustrated in a particular order, these operations may be performed in any suitable order. Further, additional operations which are not illustrated may also be performed without departing from the scope of the present disclosure. Also, various ones of the operations discussed herein with respect to FIGS. 4A-4L may be modified in accordance with the present disclosure to fabricate others of microelectronic assembly 100 disclosed herein.

FIG. 4A illustrates a peelable carrier 401 subsequent to attaching a buffer material 105 on a top surface and a bottom surface of the carrier 401. The carrier 401 may include any suitable carrier for providing mechanical stability during manufacturing operations, and in some embodiments, may include a prepreg organic core with a metal layer 402 (e.g., in some embodiments, the copper layer is a copper clad layer (CCL)) and a liner 137 on a top surface and a bottom surface. The liner 137 may include any suitable material, may have any suitable dimensions, and may function as an etch stop, as described above with reference to FIG. 1B. The buffer material 105 may be attached to the top surface and the bottom surface of the carrier 401 using any suitable technique, such as a temporary bonding material (e.g., a removable adhesive, not shown). The buffer material 105 may be deposited using any suitable technique, including lamination or spin coating, and may be formed in multiple layers to achieve a desired thickness.

FIG. 4B illustrates an assembly subsequent to depositing a glass layer 103 having via openings 111 on the buffer material 105 at the top and bottom surfaces of the assembly of FIG. 4A. The glass layers 103 may be attached with the second surface 170-2 facing towards the carrier 401. The via openings 111 may be formed using any suitable technique, such as laser etching, lithography, or plasma etching.

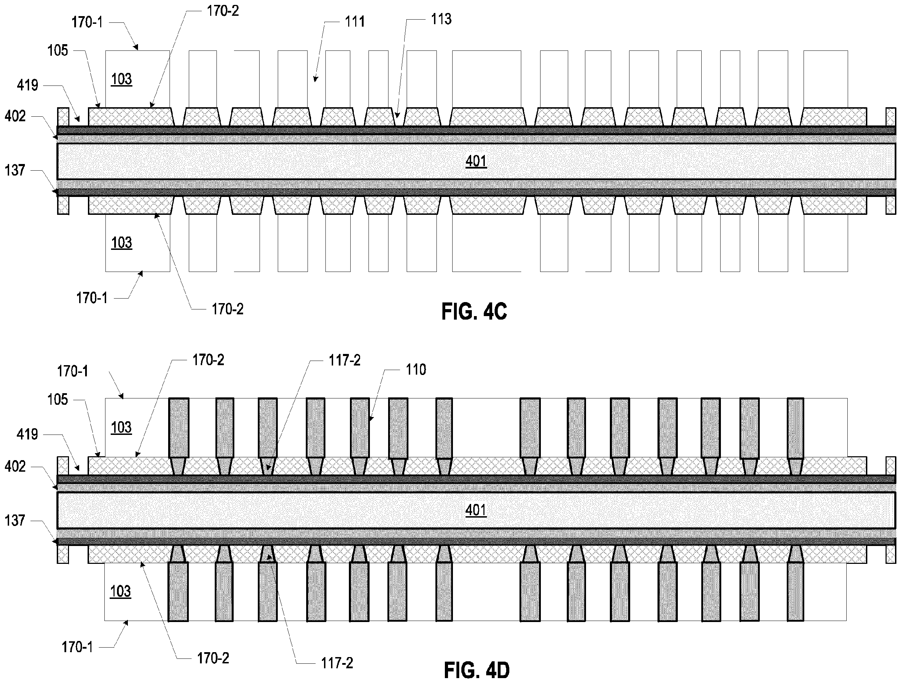

FIG. 4C illustrates an assembly subsequent to forming via openings 113 through the buffer material 105 at the bottom of the via openings 111 and forming plating clamp openings 419. The via openings 113 and the plating clamp openings 419 may be formed using any suitable technique, including laser drilling and a desmear cleaning.

FIG. 4D illustrates an assembly subsequent to depositing a conductive material in the via openings 111, 113 of the assembly of FIG. 4C to form TGVs 110 and conductive vias 117-2. The conductive material may be deposited using any suitable process, such as electroplating. The conductive material may include any suitable material, as described above with reference to FIG. 1A. In some embodiments, the surfaces of the assembly (e.g., first surfaces 170-1 of the glass layers 103) may be planarized (e.g., by grinding) to remove excess conductive material and be flush with the respective first surfaces 170-1 of the glass layers 103.

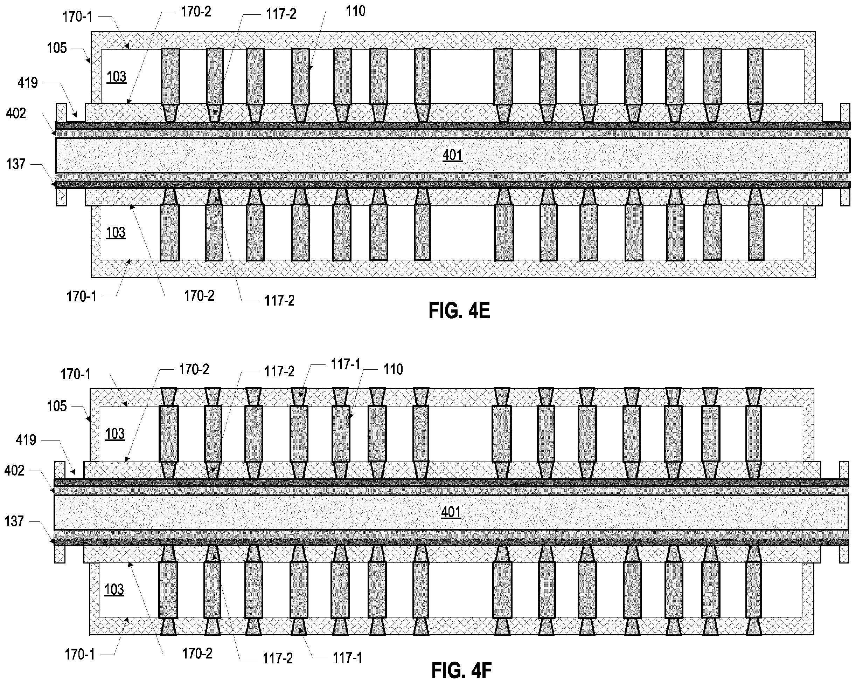

FIG. 4E illustrates an assembly subsequent to depositing a buffer material 105 on and around the glass layers 103 at the top and bottom surfaces of the assembly of FIG. 4D. The buffer material 105 may be deposited using any suitable technique, including lamination.

FIG. 4F illustrates an assembly subsequent to forming via openings and depositing a conductive material in the via openings to form conductive vias 117-1. The via openings may be formed and the conductive material may be deposited using any suitable technique, such as described above with reference to FIGS. 4C and 4D.

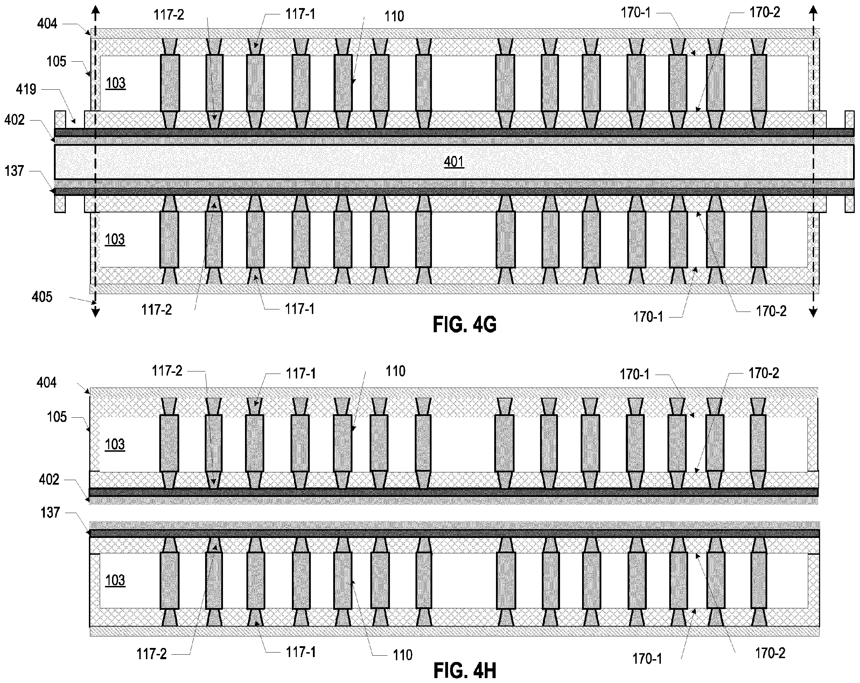

FIG. 4G illustrates an assembly subsequent to depositing a protective material 404 at respective top and bottom surfaces of the assembly of FIG. 4F and removing the carrier 401 (e.g., by sawing along the saw streets 405). The protective material 404 may include any suitable material to protect against etching, such as an adhesive, a polymer film, or a mylar film, and may be deposited using any suitable technique, including lamination.

FIG. 4H illustrates two assemblies subsequent to removal of the carrier 401 that include a glass layer 103 with TGVs 110 surrounded by a buffer material 105 having conductive vias 117-1, 117-2, a protective material 404 on the first conductive vias 117-1, and a liner 137 and a metal layer 402 on the second conductive vias 117-2. In some embodiments, the assemblies of FIG. 4H may be trimmed to a standard panel size or may be trimmed to half panel or quarter panel sizes.

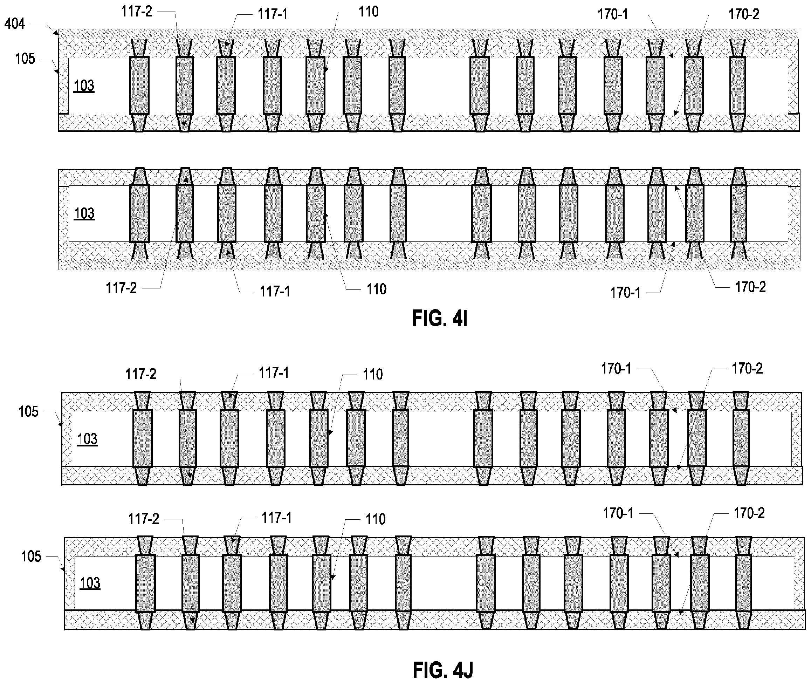

FIG. 4I illustrates an assembly subsequent to removing the liner 137 and the metal layer 402 on the second conductive vias 117-2. The liner 137 and the metal layer 402 may be removed using any suitable technique, including selective etching.

FIG. 4J illustrates an assembly subsequent to removing the protective material 404 on the first conductive vias 117-1 and inverting the bottom assembly. The protective material 404 may be removed using any suitable technique, including peeling and cleaning.

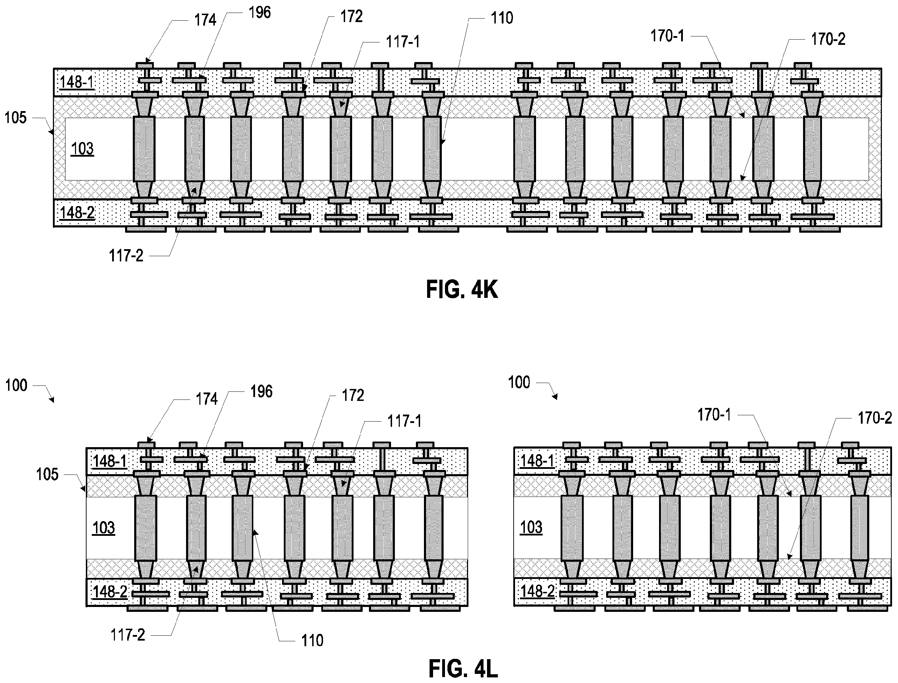

FIG. 4K illustrates an assembly subsequent to forming a first substrate 148-1 and a second substrate 148-2 on respective top and bottom surfaces of the assembly of FIG. 4J. The first and second substrates 148-1, 148-2 may include conductive pathways 196 between first conductive contacts 172 and second conductive contacts 174. The first and second substrates 148-1, 148-2 may be manufactured using any suitable technique, such as a PCB technique or a redistribution layer technique.

FIG. 4L illustrates an assembly subsequent to singulating the assembly of FIG. 4K into individual units. The assembly may be singulated into individual units using any suitable technique, including sawing. The assemblies of FIG. 4L may be microelectronic assemblies 100 themselves, as shown, or further operations may be performed on the assemblies of FIG. 4L. For example, electrically coupling the die 114-1, 114-2 to the first substrate 148-1 by forming interconnects 150 and overmolding the die 114-1, 114-2 with an insulating material 133, depositing solder 136 on a bottom surface of conductive contacts 172 of the second substrate 148-2, and/or electrically coupling solder 136 to a circuit board 131 to form interconnects 190, similar to the microelectronic assembly 100 of FIG. 1A.

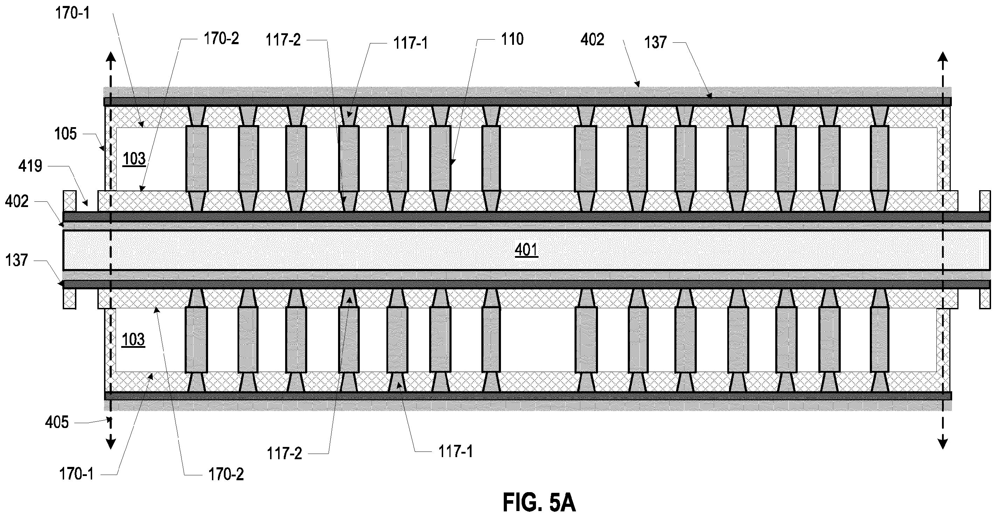

FIGS. 5A-5D are side, cross-sectional views of various stages in an example process for manufacturing the microelectronic assembly 100 of FIG. 1B, in accordance with various embodiments. FIG. 5A illustrates an assembly subsequent to depositing a liner 137 and a metal layer 402 on respective top and bottom surfaces of the assembly of FIG. 4F (e.g., on the first conductive vias 117-1). The liner 137 may include any suitable material, as described above with reference to FIG. 1B. The metal layer 402 may include any suitable material, such as copper. The liner 137 and the metal layer 402 may be deposited using any suitable technique, such as electroplating.

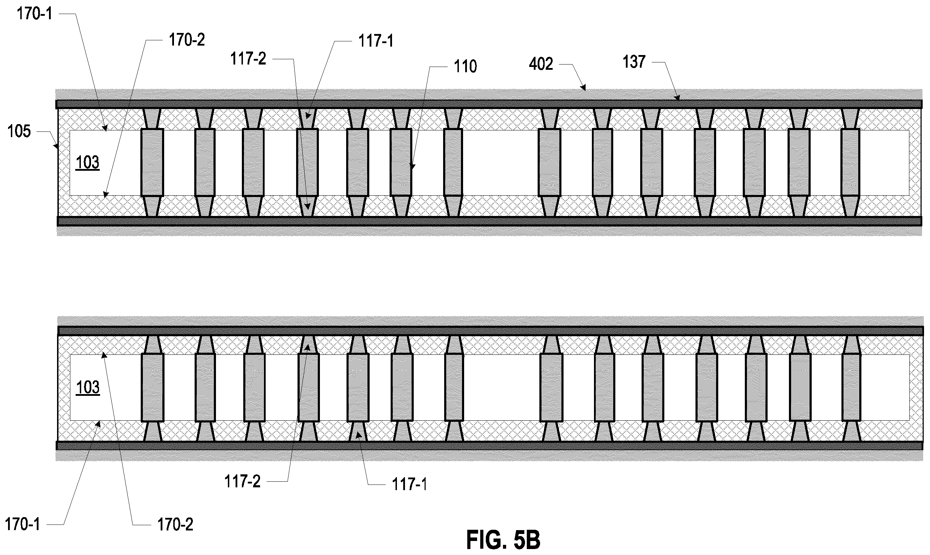

FIG. 5B illustrates an assembly subsequent to removal of the carrier 401 (e.g., by sawing along the saw streets 405 in FIG. 5A), where two individual assemblies include a glass layer 103 with TGVs 110 surrounded by a buffer material 105 having conductive vias 117-1, 117-2, and a liner 137 and a metal layer 402 on the first and second conductive vias 117-1, 117-2. In some embodiments, the assemblies of FIG. 5B may be trimmed to a standard panel size or may be trimmed to half panel or quarter panel sizes.

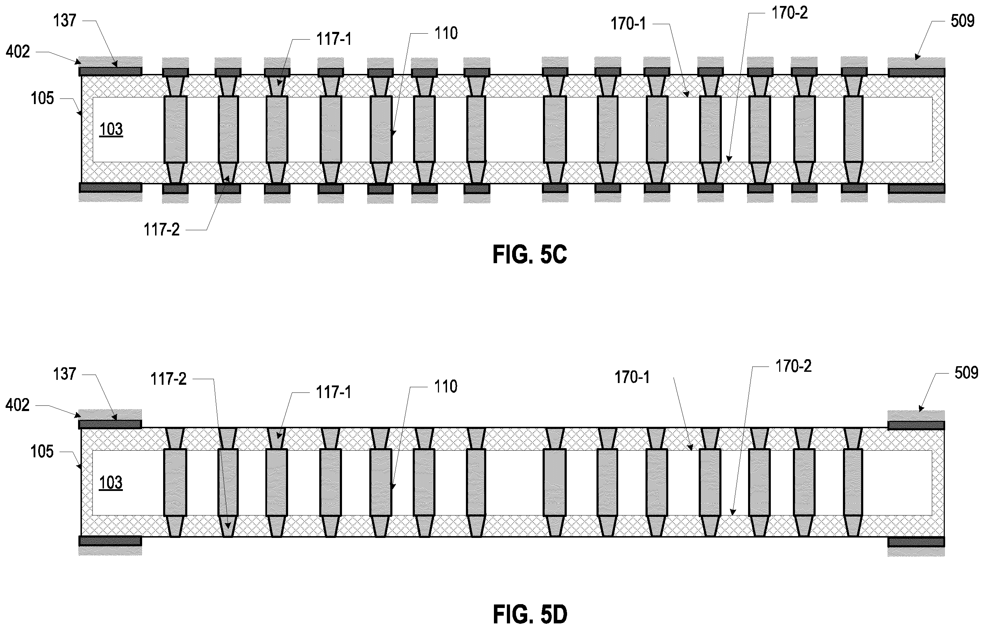

FIG. 5C illustrates an assembly of FIG. 5B subsequent to selectively patterning the liner 137 and the metal layer 402 to form a frame 509 along a perimeter of the assembly and conductive pads at the top and bottom surfaces of the assembly (e.g., for conductive contacts 172, 174, as shown in FIG. 1B). The frame 509 may provide additional support and stability to the assembly of FIG. 5C during further manufacturing operations and may be removed during singulation. Further operations may be performed on the assembly of FIG. 5C, for example, the operations as described above with reference to FIGS. 4K and 4L to form an assembly similar to the microelectronic assembly 100 of FIG. 1B.

FIG. 5D illustrates an alternate assembly to FIG. 5C, where the liner 137 and the metal layer 402 are selectively patterned to form a frame 509 along a perimeter of the assembly. As described above with reference to FIG. 5C, the frame 509 may provide additional support and stability to the assembly of FIG. 5D during further manufacturing operations and may be removed during singulation. Further operations may be performed on the assembly of FIG. 5D, for example, the operations as described above with reference to FIGS. 4K and 4L to form an assembly similar to the microelectronic assembly 100 of FIG. 1A.

FIGS. 6A-6F are side, cross-sectional views of various stages in an example process for manufacturing a microelectronic assembly 100 of FIG. 2, in accordance with various embodiments. FIG. 6A illustrates an assembly subsequent to attaching a glass layer 103 having TGVs 110 to a top surface and a bottom surface of a first carrier 601-1. The glass layer 103 may be attached using any suitable technique, such as a temporary bonding material 607. The glass layers 103 may be attached with the first surface 170-1 facing towards the first carrier 601-1. The first carrier 601-1 may include any suitable carrier that provides stability and support during manufacturing.

FIG. 6B illustrates an assembly subsequent to depositing a buffer material 105 on and around the glass layers 103 at the top and bottom surfaces of the assembly of FIG. 6A, forming via openings and depositing a conductive material in the via openings to form conductive vias 117-2, and forming a second substrate 148-2 on respective top and bottom surfaces of the assembly. The second substrate 148-2 may include conductive pathways 196 between first conductive contacts 172 and second conductive contacts 174. The buffer material 105 may be deposited using any suitable technique, including lamination. The via openings may be formed and the conductive material may be deposited using any suitable technique, such as described above with reference to FIGS. 4C and 4D. The second substrate 148-2 may be manufactured using any suitable technique, such as a PCB technique or a redistribution layer technique. The second substrate 148-2 may include any suitable number of metal layers and the metal layers may have any suitable thickness, as described above with reference to FIG. 2. In some embodiments, the buffer material 105 may be included as part of the formation of the second substrate 148-2, and the buffer material 105 and the dielectric material of the second substrate 148-2 may include a same material, for example, an organic dielectric material.

FIG. 6C illustrates two assemblies subsequent to detaching the first carrier 601-1 (e.g., by sawing along the saw streets 605 in FIG. 6B) and removing the temporary bonding material 607.

FIG. 6D illustrates the two assemblies of FIG. 6C subsequent to inverting the two assemblies and attaching to a second carrier 601-2 by a temporary bonding material 607. As shown in FIG. 6D, the assemblies are attached to the second carrier 601-2 with the second substrate 148-2 facing towards the second carrier 601-2.

FIG. 6E illustrates an assembly subsequent to depositing a buffer material 105 on the glass layers 103 at the top and bottom surfaces of the assembly of FIG. 6D, forming via openings and depositing a conductive material in the via openings to form conductive vias 117-1, and forming a first substrate 148-1 on respective top and bottom surfaces of the assembly. The first substrate 148-1 may include conductive pathways 196 between first conductive contacts 172 and second conductive contacts 174. The buffer material 105 may be deposited using any suitable technique, including lamination. The via openings may be formed and the conductive material may be deposited using any suitable technique, such as described above with reference to FIGS. 4C and 4D. The first substrate 148-1 may be manufactured using any suitable technique, such as a PCB technique or a redistribution layer technique. The first substrate 148-1 may include any suitable number of metal layers and the metal layers may have any suitable thickness, as described above with reference to FIG. 2, and the number of metal layers and the thickness of the metal layers in the first substrate 148-1 may be different as compared to the second substrate 148-2. In some embodiments, the buffer material 105 may be included as part of the formation of the first substrate 148-1, and the buffer material 105 and the dielectric material of the first substrate 148-1 may include a same material, for example, an organic dielectric material.

FIG. 6F illustrates an assembly subsequent to removal of the second carrier 601-2 (e.g., sawing along the saw streets 605 in FIG. 6E), removing the temporary bonding material 607, and singulating the assembly into individual units. The assembly may be singulated into individual units using any suitable technique, including sawing. The assemblies of FIG. 6F may be microelectronic assemblies 100 themselves, as shown, or further operations may be performed on the assemblies of FIG. 6F. For example, electrically coupling the die 114-1, 114-2 to the first substrate 148-1 by forming interconnects 150 and overmolding the die 114-1, 114-2 with an insulating material 133, depositing solder 136 on a bottom surface of conductive contacts 172 of the second substrate 148-2, and/or electrically coupling solder 136 to a circuit board 131 to form interconnects 190, similar to the microelectronic assembly 100 of FIG. 2.

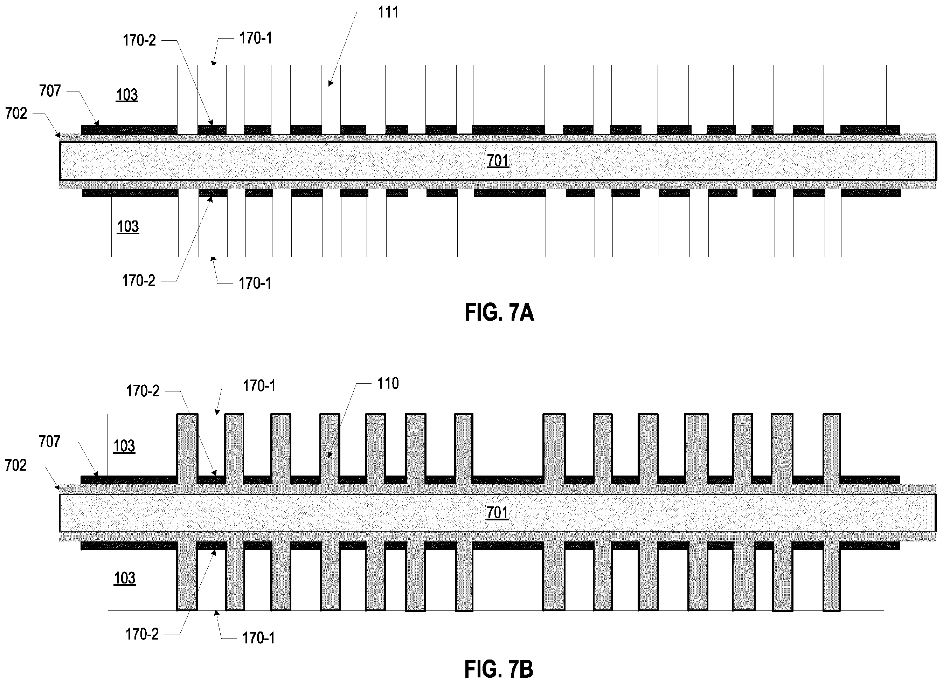

FIGS. 7A-7K are side, cross-sectional views of various stages in an example process for manufacturing a microelectronic assembly 100 of FIG. 3, in accordance with various embodiments. FIG. 7A illustrates an assembly subsequent to attaching a first glass layer 103-1 having via openings 111 to a top surface and a bottom surface of a carrier 701 by an adhesive material 107 (e.g., temporary bonding material), and removing the adhesive material 107 at the bottom of the via openings 111. The first glass layer 103-1 may be attached with the second surface 170-2 facing towards the carrier 701. The carrier 701 may include any suitable carrier that provides stability and support during manufacturing and may include a metal layer 702 at top and bottom surfaces of the carrier 701.

FIG. 7B illustrates an assembly subsequent to depositing a conductive material in the via openings to form TGVs 110. The conductive material may be deposited using any suitable technique, such as electroplating.

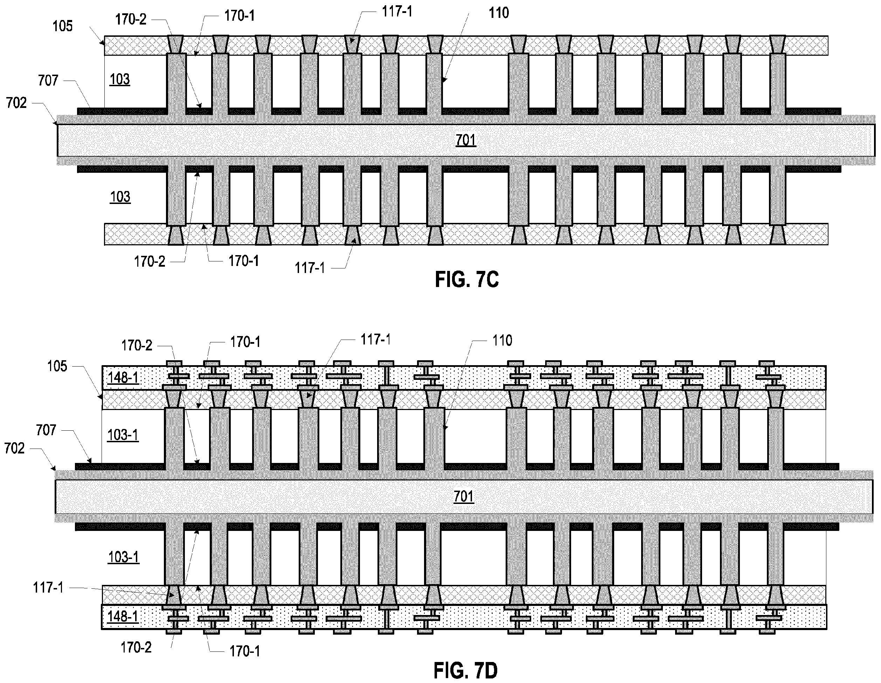

FIG. 7C illustrates an assembly subsequent to depositing a buffer material 105 on the first glass layer 103-1 at the top and bottom surfaces of the assembly of FIG. 7B, forming via openings, and depositing a conductive material in the via openings to form conductive vias 117-1. The buffer material 105 may be deposited using any suitable technique, including lamination. The via openings may be formed and the conductive material may be deposited using any suitable technique, such as described above with reference to FIGS. 4C and 4D.

FIG. 7D illustrates an assembly subsequent to forming a first substrate 148-1 on respective top and bottom surfaces of the assembly of FIG. 7C. The first substrate 148-1 may include conductive pathways 196 between first conductive contacts 172 and second conductive contacts 174. The first substrate 148-1 may be manufactured using any suitable technique, such as a PCB technique or a redistribution layer technique.

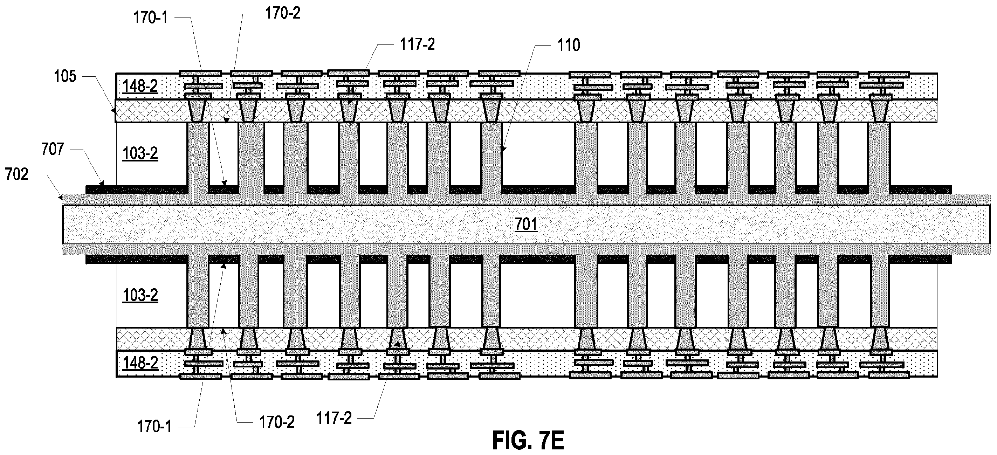

FIG. 7E illustrates an assembly similar to the assembly of FIG. 7D except that the assembly of FIG. 7E include a second glass layer 103-2 attached with the first surface 170-1 facing towards the carrier 701, and a second surface of the second glass layer 103-2 includes a buffer material 105 having conductive vias 117-2 and a second substrate 148-2 formed thereon. The assembly of FIG. 7E may be formed using any suitable techniques, such as described above with reference to FIGS. 7A-7D.

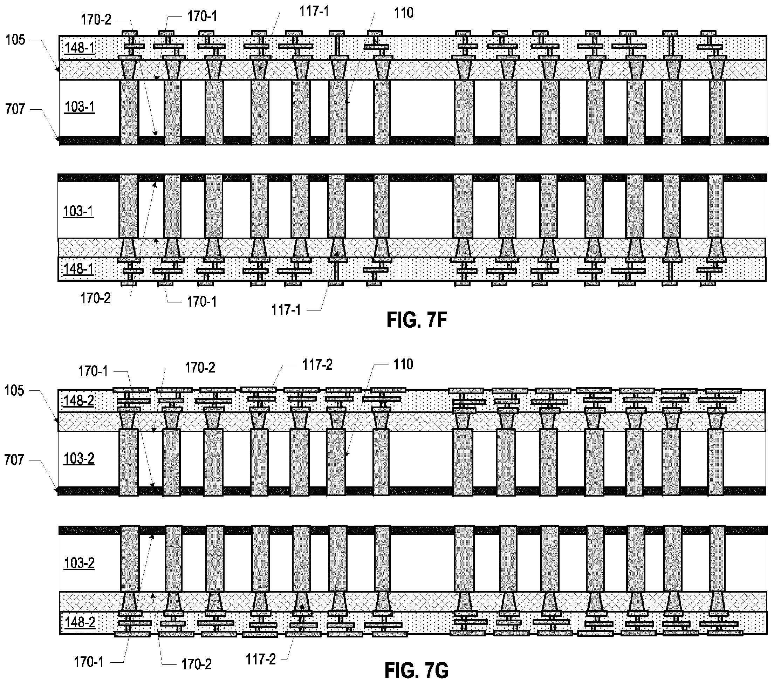

FIG. 7F illustrates the assembly of FIG. 7D subsequent to removal of the carrier 701 forming two assemblies including a first glass layer 103-1, first conductive vias 117-1, and a first substrate 148-1.

FIG. 7G illustrates the assembly of FIG. 7E subsequent to removal of the carrier 701 forming two assemblies including a second glass layer 103-2, second conductive vias 117-2, and a second substrate 148-2.

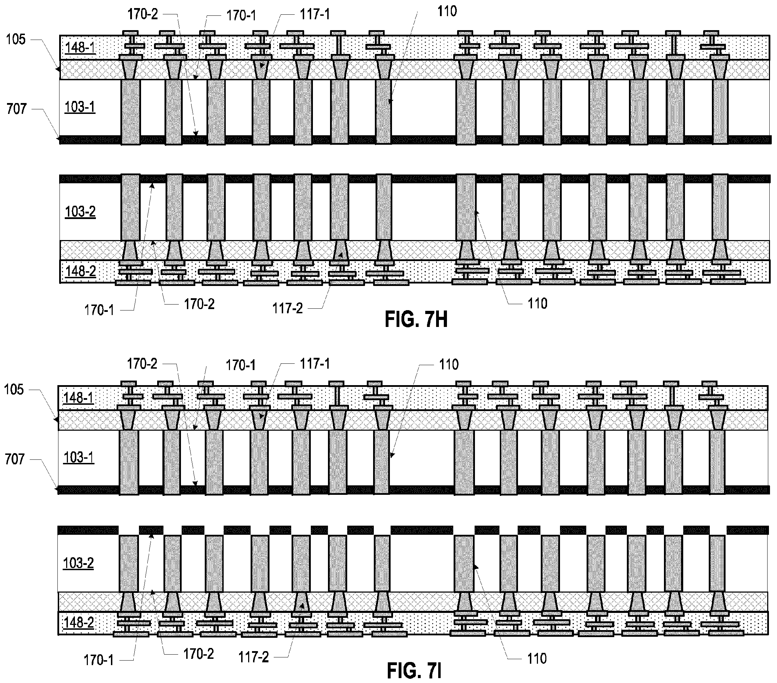

FIG. 7H illustrates an assembly including a first glass layer 103-1, first conductive vias 117-1, and a first substrate 148-1 aligned with a second glass layer 103-2, second conductive vias 117-2, and a second substrate 148-2.

FIG. 7I illustrates an assembly subsequent to removing a portion of the conductive material of TGVs 110 at a first surface 170-1 of a second glass layer 103-2. The conductive material may be removed using any suitable technique, including etching. In some embodiments, the conductive material may be removed from TGVs 110 at the second surface 170-2 of the first glass layer 103-1. In some embodiments, the conductive material may be removed from TGVs 110 at the first surface 170-1 of a second glass layer 103-2 and at the second surface 170-2 of the first glass layer 103-1. In some embodiments, adhesive material 107 may be removed.

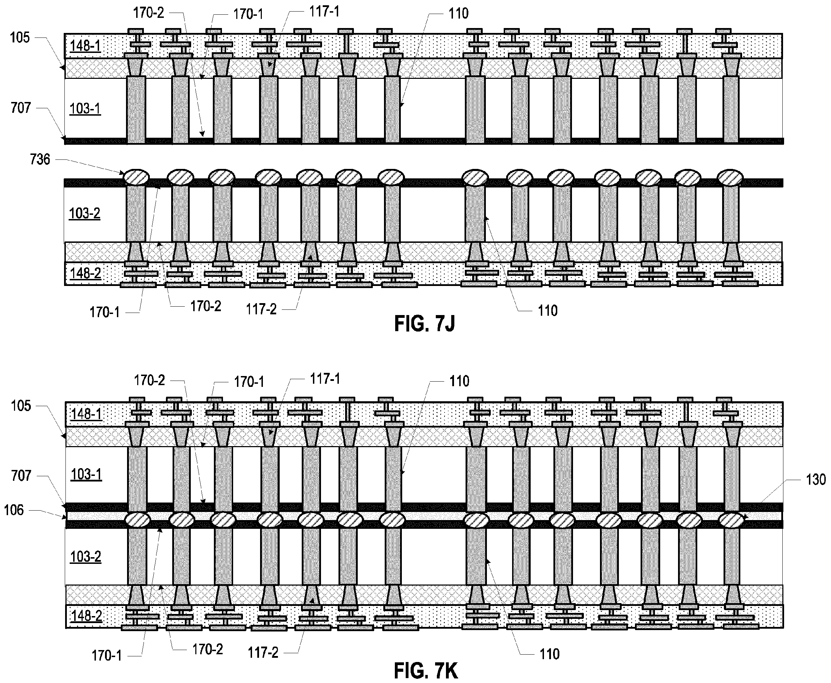

FIG. 7J illustrates an assembly subsequent to depositing solder 736 (e.g., solder bumps or balls) on the TGVs 110 at the first surface 170-1 of the second glass layer 103-2. In some embodiments, solder may be deposited on TGVs 110 at the second surface 170-2 of the first glass layer 103-1. In some embodiments, solder may be deposited on the TGVs 110 at the first surface 170-1 of the second glass layer 103-2 and on TGVs 110 at the second surface 170-2 of the first glass layer 103-1.

FIG. 7K illustrates an assembly subsequent to forming interconnects 130 and depositing an insulating material 106 around the interconnects 130. Interconnects 130 may be formed, for example, by bringing the second surface 170-2 of the first glass layer 103-1 in contact with the first surface 170-1 of the second glass layer 103-2 and subjecting the assembly to a thermal reflow process. The insulating material 106 may include any suitable material, as described above with reference to FIG. 3, and may be deposited using any suitable process, such as dispensing the insulating material 106 in liquid form, allowing the material to flow and fill the interstitial gaps around interconnects 130, and subjecting the assembly to a curing process. The assembly of FIG. 7K may be singulated into individual units using any suitable technique, including sawing. The singulated assemblies of FIG. 7K may be microelectronic assemblies 100 themselves, or may undergo further operations. For example, electrically coupling the die 114-1, 114-2 to the first substrate 148-1 by forming interconnects 150 and overmolding the die 114-1, 114-2 with an insulating material 133, depositing solder 136 on a bottom surface of conductive contacts 172 of the second substrate 148-2, and/or electrically coupling solder 136 to a circuit board 131 to form interconnects 190, similar to the microelectronic assembly 100 of FIG. 3.

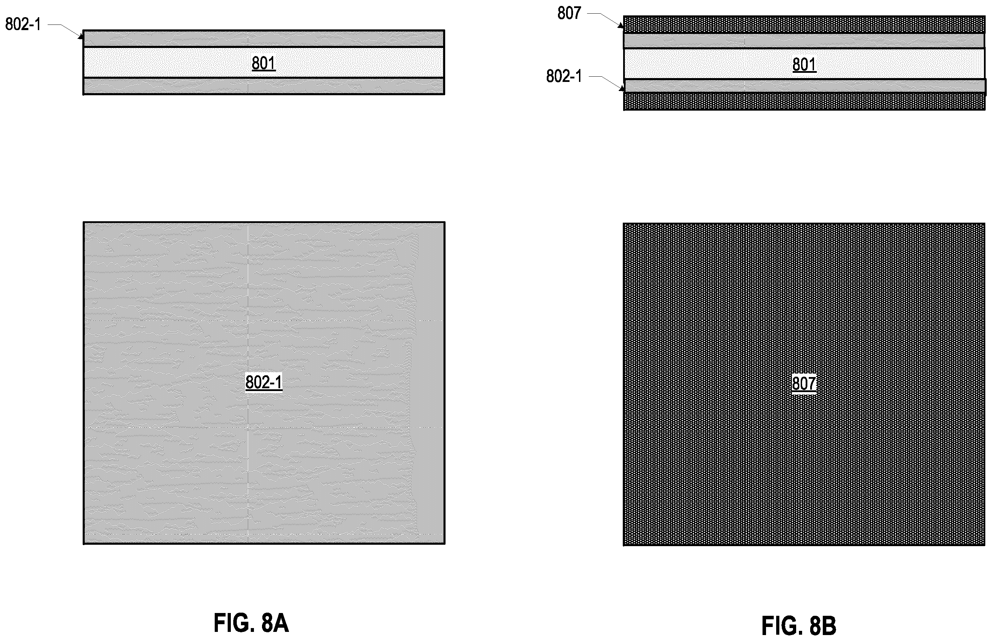

FIGS. 8A-8O are cross-sectional views and top views of various stages in an example process for manufacturing a substrate using a glass layer according to some embodiments of the present disclosure. FIG. 8A illustrates a carrier 801 with first metal layers 802-1 on top and bottom surfaces of the carrier 801. The carrier 801 may include a peelable prepreg organic core and the first metal layers 802-1 may include CCL.

FIG. 8B illustrates an assembly subsequent to depositing a conductive adhesive 807 to top and bottom surfaces of the assembly of FIG. 8A. The conductive adhesive 807 may include any suitable material, such as a polymer with metal particles (e.g., silver, nickel, gold, copper, iron, aluminum, graphite, or carbon nanotubes, etc.), and may be deposited using any suitable technique, such as lamination or slit coating.

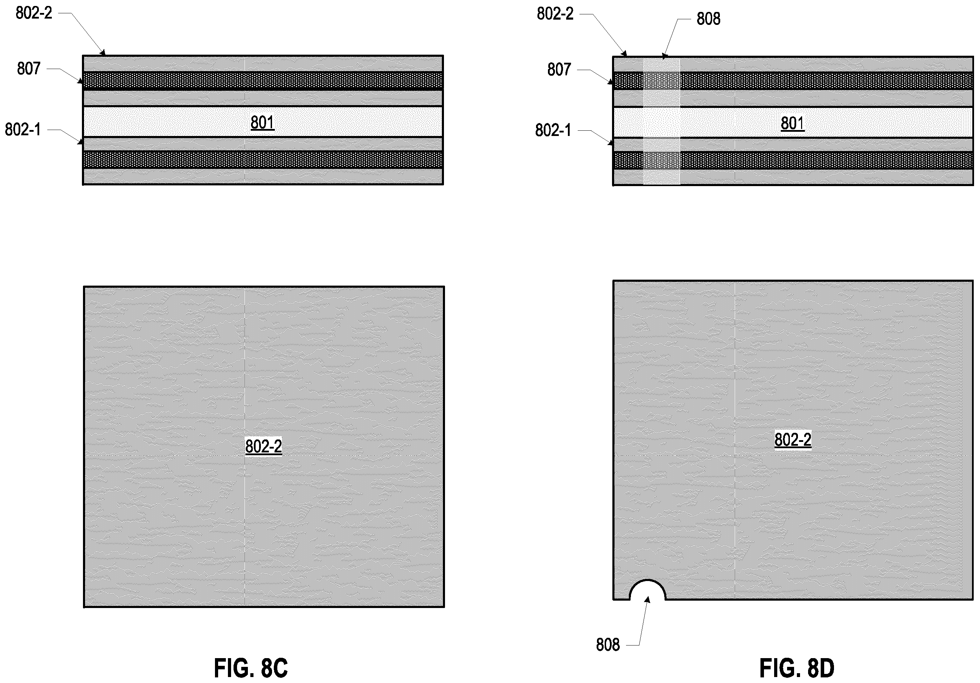

FIG. 8C illustrates an assembly subsequent to depositing a second metal layer 802-2 on top and bottom surfaces of the assembly of FIG. 8C. The second metal layer 802-2 may include any suitable material, such as copper, and may be deposited using any suitable technique such as electroplating.

FIG. 8D illustrates an assembly subsequent to forming a notch 808 in the assembly of FIG. 8C. The notch 808 may be formed using any suitable technique, such as mechanical drilling, and may have a unique number and size to enable unit level traceability (ULT) through the manufacturing process.

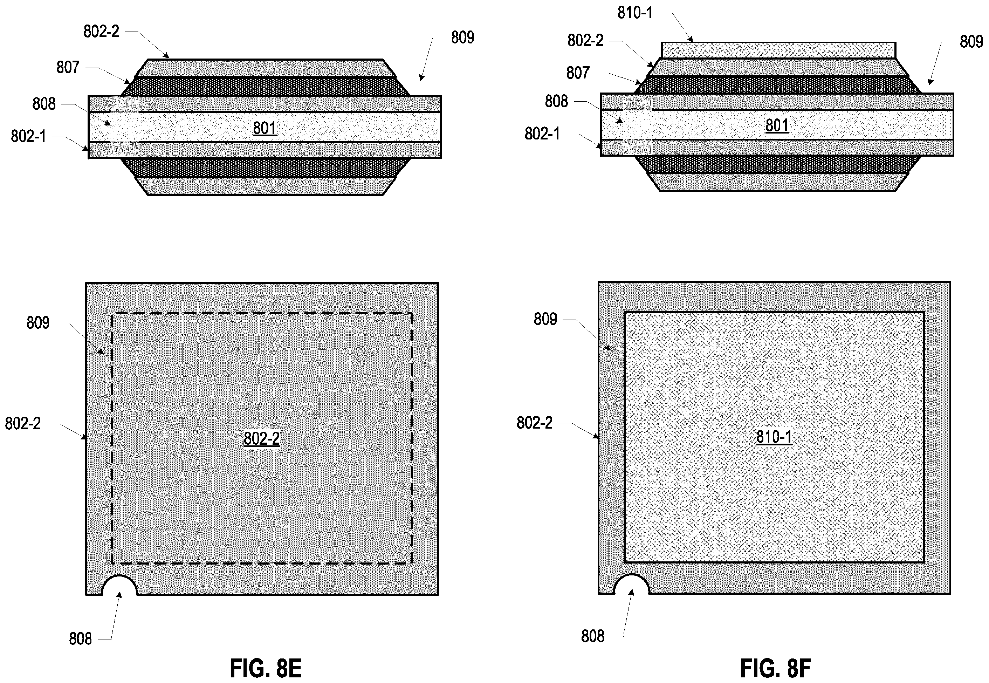

FIG. 8E illustrates an assembly subsequent to creating an inset 809 along a perimeter of the assembly of FIG. 8D. The inset 809 may be formed using any suitable technique, such as by chemical and mechanical polishing (CMP). The inset 809 may help to reduce delamination of the assembly.

FIG. 8F illustrates an assembly subsequent to depositing a first release layer 810-1 on a top surface of the assembly of FIG. 8E. The first release layer 810-1 may include any suitable material, such as a thermal debonding film or a laser debonding film, and may be deposited using any suitable technique, such as lamination.

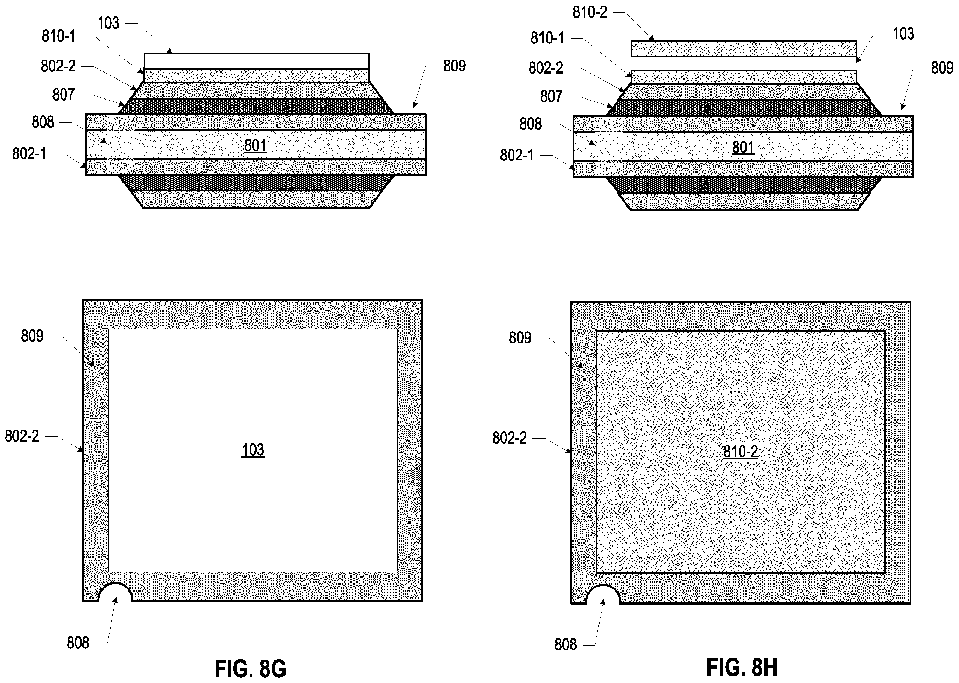

FIG. 8G illustrates an assembly subsequent to depositing a glass layer 103 on a top surface of the assembly of FIG. 8F. The glass layer 103 may be deposited using any suitable technique, including lamination.

FIG. 8H illustrates an assembly subsequent to depositing a second release layer 810-2 on a top surface of the assembly of FIG. 8G. The second release layer 810-2 may include any suitable material, such as a thermal debonding film or a laser debonding film, and may be deposited using any suitable technique, such as lamination.

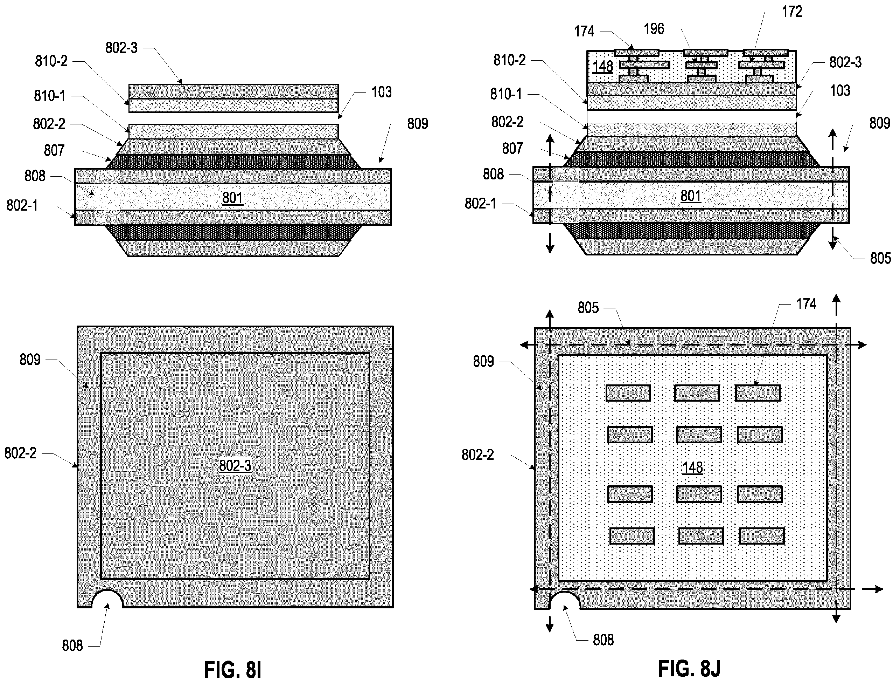

FIG. 8I illustrates an assembly subsequent to depositing a third metal layer 802-3 on top surface of the assembly of FIG. 8H. The third metal layer 802-3 may include any suitable material, such as copper, and may be deposited using any suitable technique such as electroplating.

FIG. 8J illustrates an assembly subsequent to forming a substrate 148 on a top surface of the assembly of FIG. 8I. The substrate 148 may include conductive pathways 196 between first conductive contacts 172 and second conductive contacts 174. The substrate 148 may be manufactured using any suitable technique, such as a PCB technique or a redistribution layer technique.

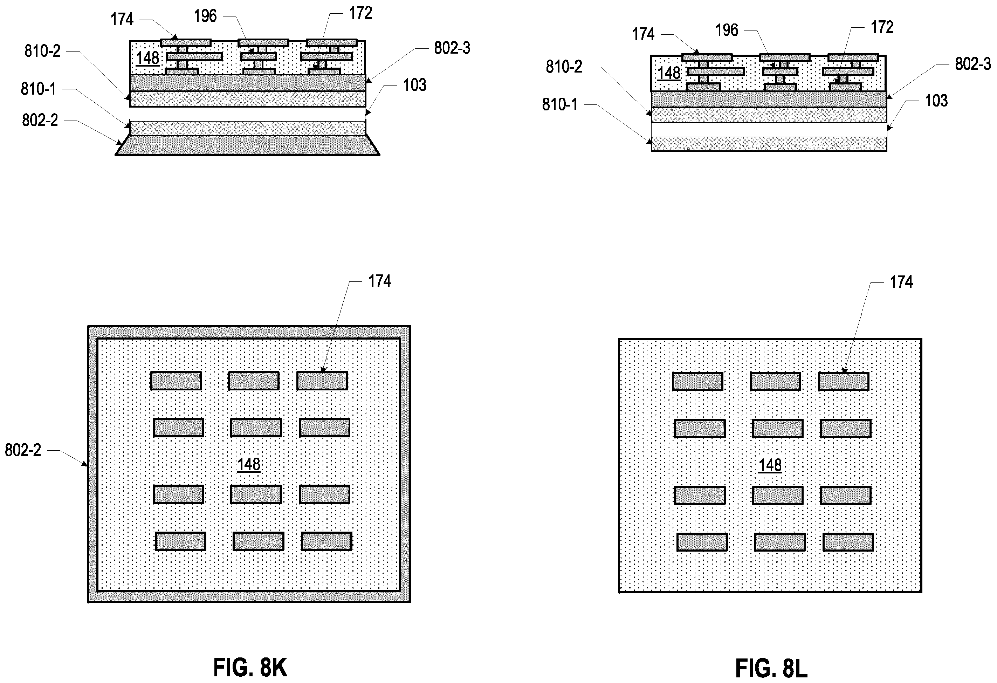

FIG. 8K illustrates an assembly subsequent to removing the carrier 801 by sawing along the saw streets 805 and by mechanically peeling off the conductive adhesive 807 of FIG. 8J.

FIG. 8L illustrates an assembly subsequent to removing the second metal layer 802-2 from a bottom surface of the assembly of FIG. 8K. The second metal layer 802-2 may be removed using any suitable technique, such as chemical etching.

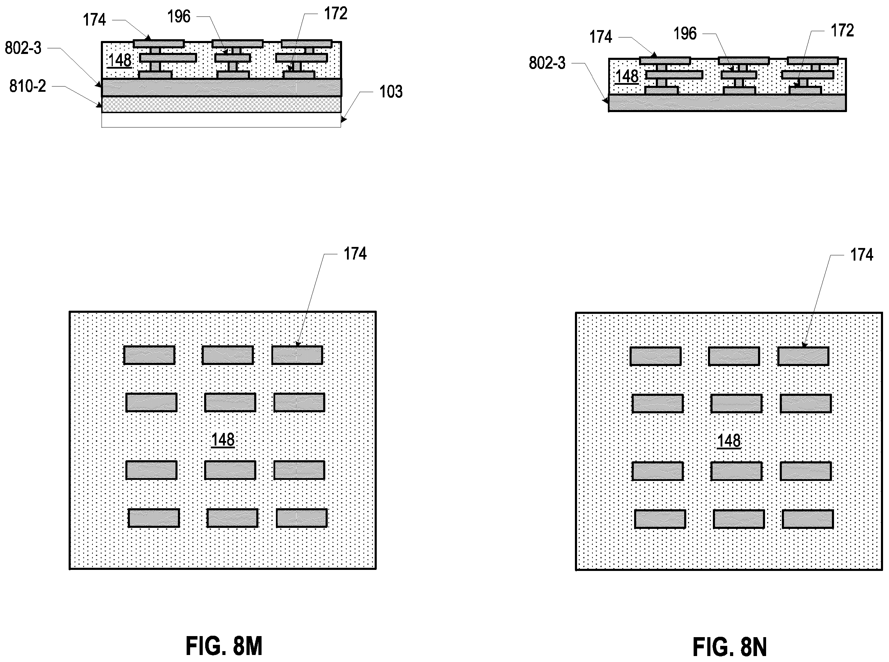

FIG. 8M illustrates an assembly subsequent to removing the first release layer 810-1 at the bottom of the assembly of FIG. 8L. The first release layer 810-1 may be removed using any suitable technique, including exposure to a laser for a laser debonding film or heat for a thermal debonding film.

FIG. 8N illustrates an assembly subsequent to removing the second release layer 810-2 and the glass layer 103 at the bottom of the assembly of FIG. 8M. The second release layer 810-2 may be removed using any suitable technique, including exposure to a laser through the glass layer 103 for a laser debonding film or heat for a thermal debonding film.

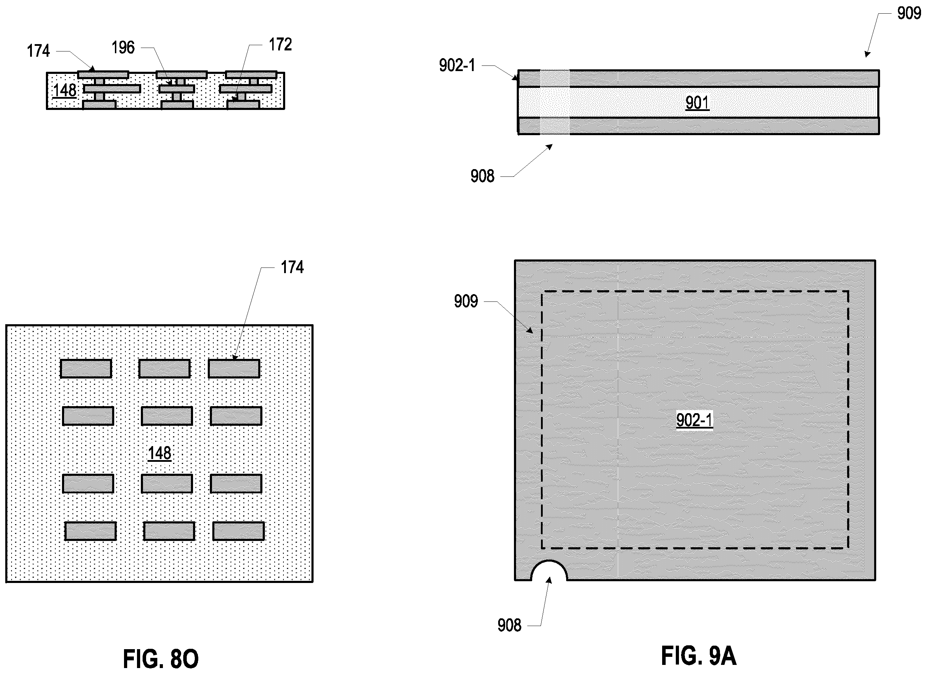

FIG. 8O illustrates an assembly subsequent to removing the third metal layer 802-3 from a bottom surface of the assembly of FIG. 8N. The third metal layer 802-3 may be removed using any suitable technique, such as chemical etching. The assembly of FIG. 8O may include a substrate 148, for example, a patch or an interposer that has a smaller pitch as compared to a substrate 148 formed on an organic core carrier. Although FIGS. 8A-8O illustrate the carrier 801 as single-sided, in some embodiments, the carrier 801 may be double-sided such that substrates 148 may be manufactured on both sides of the carrier 801.

FIGS. 9A-9G are cross-sectional views and top views of various stages in an example process for manufacturing a substrate using a glass layer according to some embodiments of the present disclosure. FIG. 9A illustrates a carrier 901 with first metal layers 902-1 on top and bottom surfaces of the carrier 901, a notch 908, and a keep out zone 909 along a perimeter of the carrier 901. The carrier 901 may include a non-peelable prepreg organic core and the first metal layers 902-1 may include CCL. The notch 908 may be formed using any suitable process, including as described above with reference to FIG. 8D.

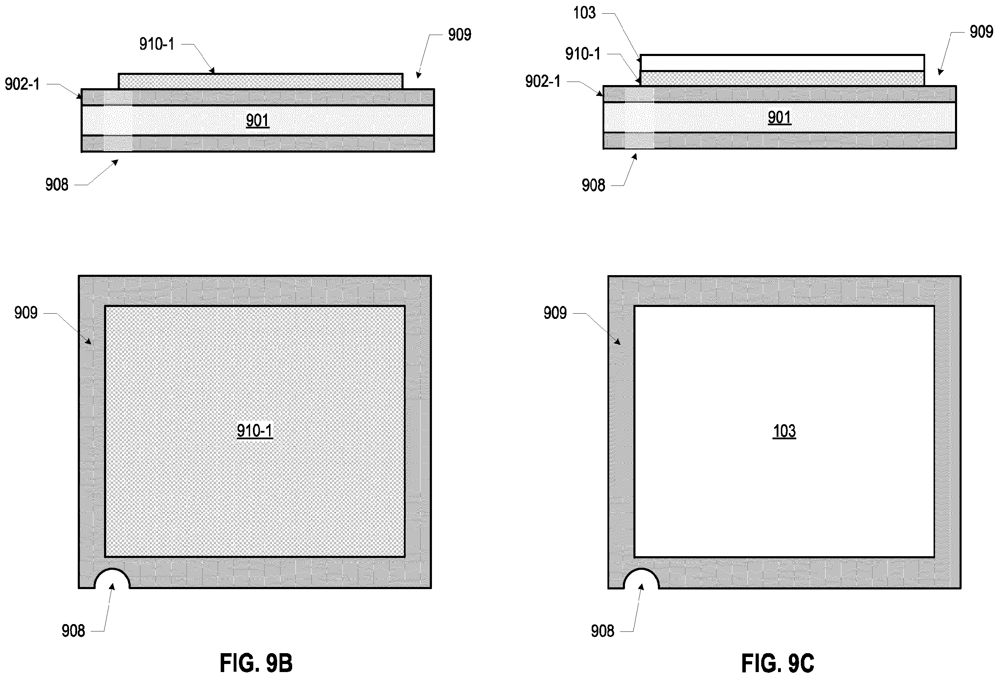

FIG. 9B illustrates an assembly subsequent to depositing a first release layer 910-1 on a top surface of the assembly of FIG. 9A. The first release layer 910-1 may include any suitable material, such as a thermal debonding film, and may be deposited using any suitable technique, such as lamination.

FIG. 9C illustrates an assembly subsequent to depositing a glass layer 103 on a top surface of the assembly of FIG. 9B. The glass layer 103 may be deposited using any suitable technique, including lamination.

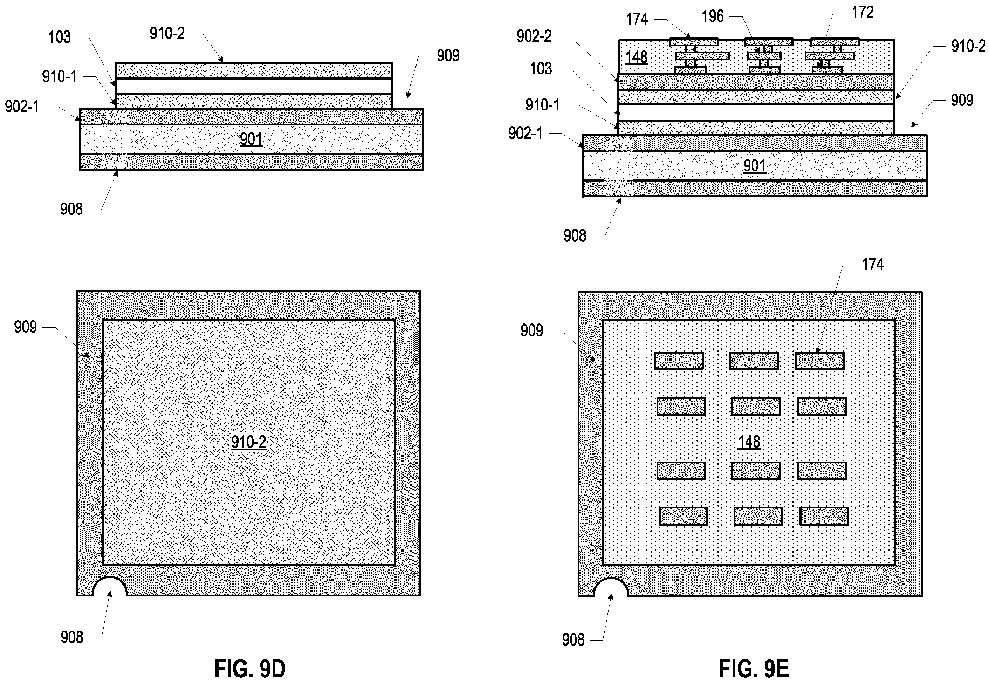

FIG. 9D illustrates an assembly subsequent to depositing a second release layer 910-2 on a top surface of the assembly of FIG. 9C. The second release layer 910-2 may include any suitable material, such as a thermal debonding film or a laser debonding film, and may be deposited using any suitable technique, such as lamination.

FIG. 9E illustrates an assembly subsequent to depositing a second metal layer 902-2 on top surface of the assembly of FIG. 9E and forming a substrate 148 on the second metal layer 902-2. The second metal layer 902-2 may include any suitable material, such as copper, and may be deposited using any suitable technique such as electroplating. The substrate 148 may include conductive pathways 196 between first conductive contacts 172 and second conductive contacts 174. The substrate 148 may be manufactured using any suitable technique, such as a PCB technique or a redistribution layer technique.

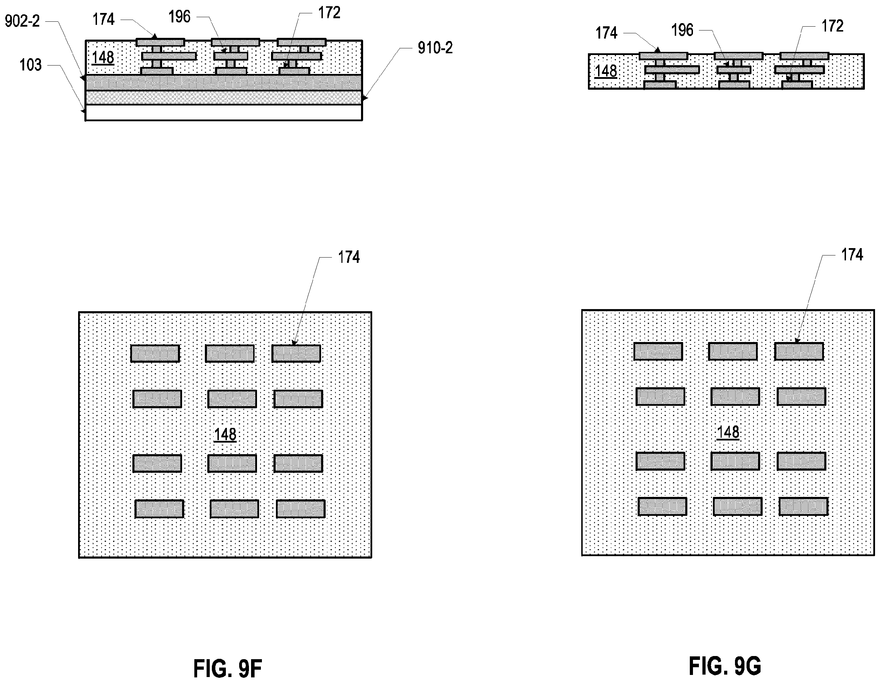

FIG. 9F illustrates an assembly subsequent to removing the carrier 901 from the assembly of FIG. 9E by the first release layer 910-1. The first release layer 910-1 may be removed using any suitable technique, including exposure to heat for a thermal debonding film.

FIG. 9G illustrates an assembly subsequent to removing the glass layer 103 at the bottom of the assembly of FIG. 9F by the second release layer 910-2 and removing the second metal layer 902-2. The second release layer 910-2 may be removed using any suitable technique, including exposure to a laser through the glass layer 103 for a laser debonding film or exposure to heat for a thermal debonding film. The second metal layer 902-2 may be removed using any suitable technique, such as chemical etching. The assembly of FIG. 9G may include a substrate 148, for example, a patch or an interposer that has a smaller pitch as compared to a substrate 148 formed on an organic core carrier. Although FIGS. 9A-9G illustrate the carrier 901 as single-sided, in some embodiments, the carrier 901 may be double-sided such that substrates 148 may be manufactured on both sides of the carrier 901.

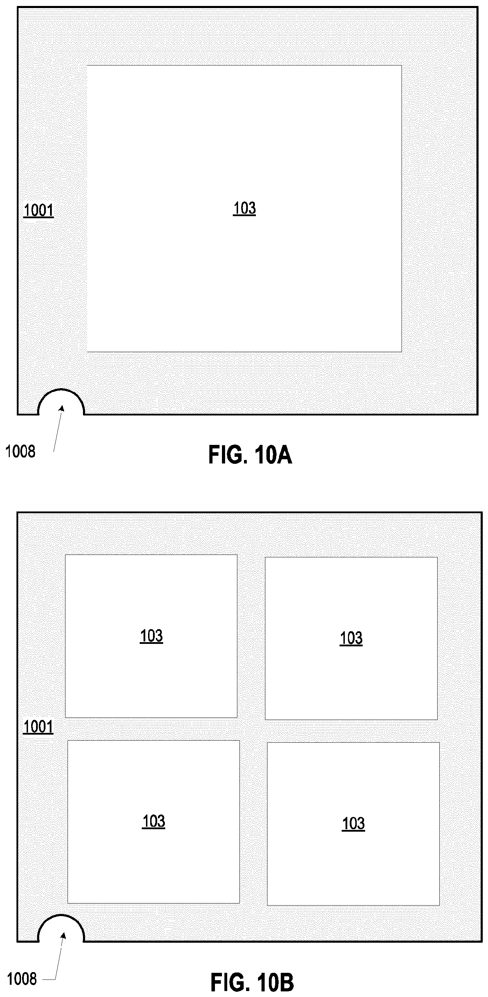

FIGS. 10A and 10B are simplified top views illustrating example arrangements of a manufacturing step of a microelectronic assembly according to some embodiments of the present disclosure. FIGS. 10A and 10B illustrate a carrier 1001 with a notch 1008 and a glass layer 103 on a top surface (e.g., as shown in FIGS. 8G and 9C). As shown in FIG. 10A, the glass layer 103 may include a single glass layer 103 (e.g., full panel size). FIG. 10B shows that the glass layer 103 may have more than one glass layer 103, including, as shown, four glass layers 103. If a thermal debonding release film is used, the glass layers 103 may be detached using a thermal sliding process. The multiple glass layers 103 may enable a reconstitution process and flexibility in terms of form factor for manufacturing substrates (e.g., substrates 148 of FIGS. 8 and 9). Although FIGS. 10A and 10B show the glass layers 103 having a particular size, shape, and arrangement, the glass layers 103 may have any suitable size, shape, and arrangement. For example, in some embodiments, the glass layer 103 may include a glass wafer having a circular shape. Further, the glass layer 103 may not include glass, but may include a silicon wafer instead.

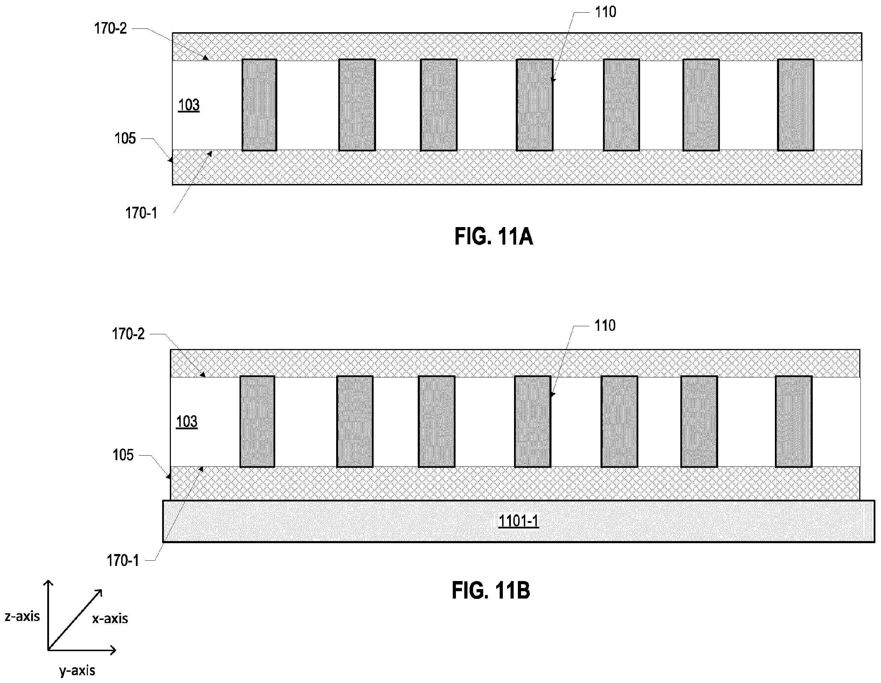

FIGS. 11A-11H are simplified cross-sectional views illustrating various manufacturing steps of an example microelectronic assembly according to some embodiments of the present disclosure. FIG. 11A illustrates an assembly including a glass layer 103 with TGVs 110 and a buffer material 105 on a first surface 170-1 and a second surface 170-2 of the glass layer 103.

FIG. 11B illustrates an assembly subsequent to attaching the assembly of FIG. 11A to a first carrier 1101-1 with the first surface 170-1 facing towards the first carrier 1101-1.

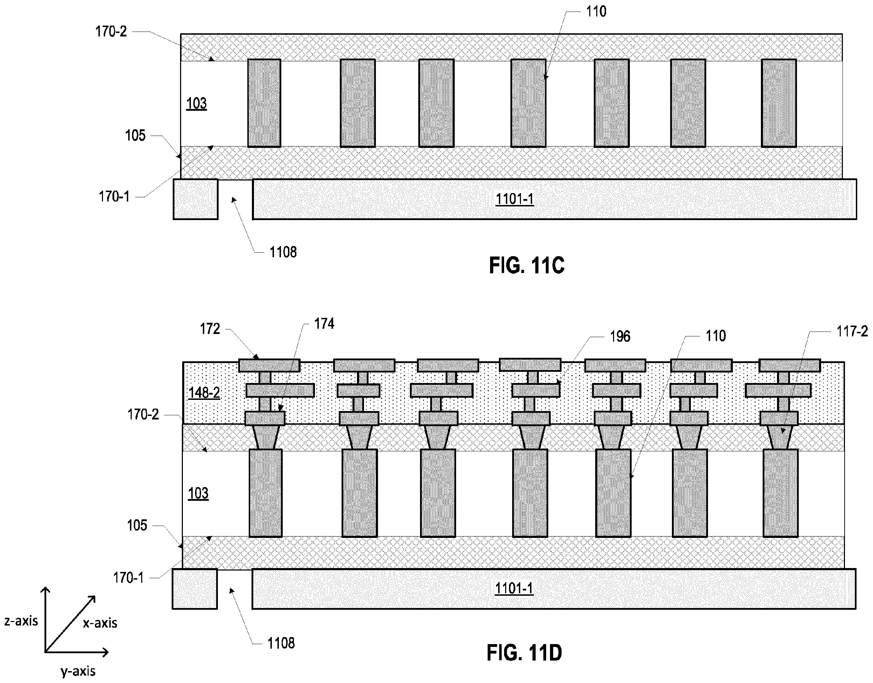

FIG. 11C illustrates an assembly subsequent to forming a notch 1108 in the assembly of FIG. 11B. The notch 1108 may be formed using any suitable technique, such as mechanical drilling, and may have a unique number and size to enable unit level traceability (ULT) through the manufacturing process.

FIG. 11D illustrates an assembly subsequent to forming via openings in the buffer material 105 at the second surface 170-2, depositing a conductive material in the via openings to form conductive vias 117-2, and forming a second substrate 148-2 on the top surface of the assembly of FIG. 11C. The via openings may be formed and the conductive material may be deposited using any suitable technique, such as laser drilling and electroplating. The second substrate 148-2 may include conductive pathways 196 between first conductive contacts 172 and second conductive contacts 174. The second substrate 148-2 may be manufactured using any suitable technique, such as a PCB technique or a redistribution layer technique.

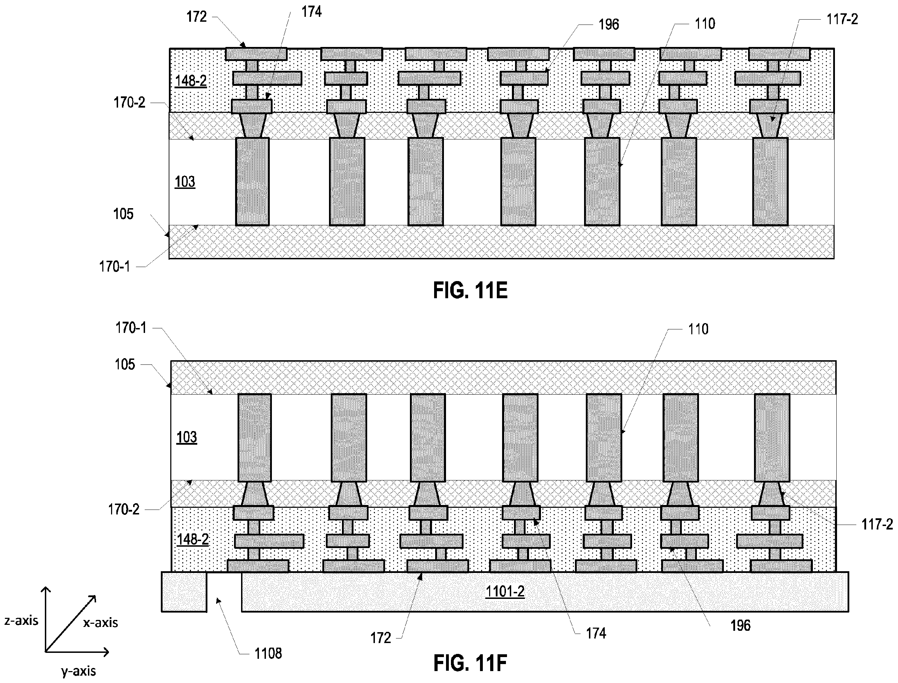

FIG. 11E illustrates an assembly subsequent to removing the first carrier 1101-1.

FIG. 11F illustrates an assembly subsequent to inverting the assembly of FIG. 11E and attaching the second substrate 148-2 to a second carrier 1101-2 including a notch 1108.

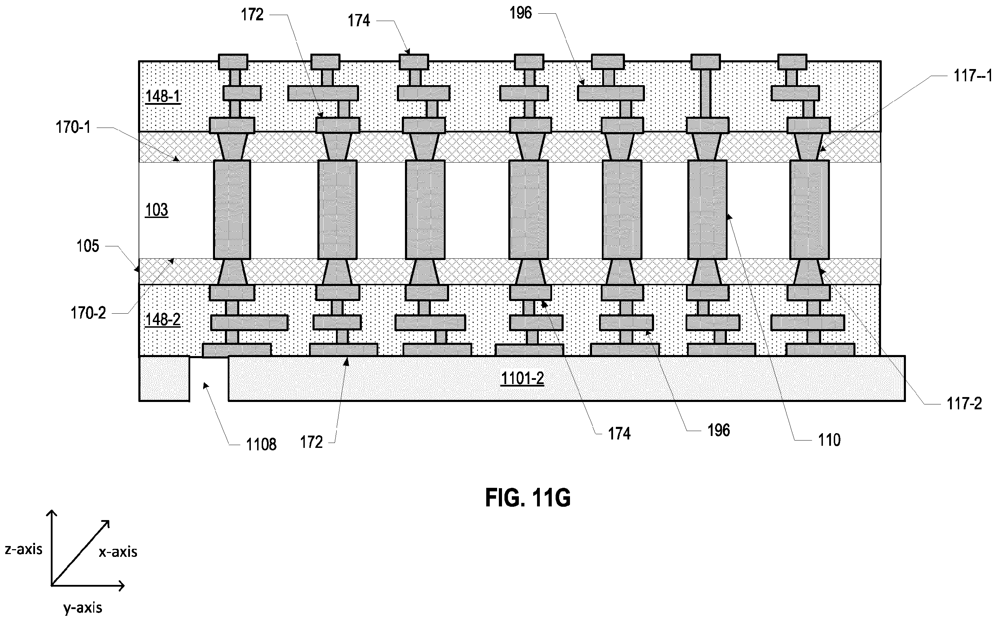

FIG. 11G illustrates an assembly subsequent to forming via openings in the buffer material 105 at the first surface 170-1, depositing a conductive material in the via openings to form conductive vias 117-1, and forming a first substrate 148-1 on a top surface of the assembly of FIG. 11F. The via openings may be formed and the conductive material may be deposited using any suitable technique, such as laser drilling and electroplating. The first substrate 148-1 may include conductive pathways 196 between first conductive contacts 172 and second conductive contacts 174. The first substrate 148-1 may be manufactured using any suitable technique, such as a PCB technique or a redistribution layer technique.

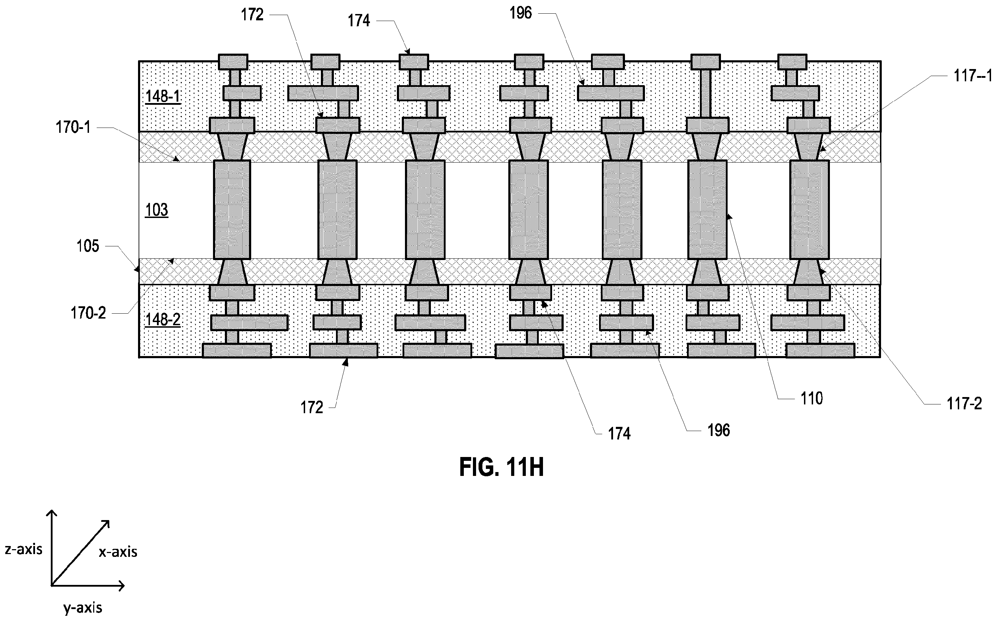

FIG. 11H illustrates an assembly subsequent to removing the second carrier 1101-2. If multiple assemblies are manufactured together, the assemblies may be singulated. The assembly of FIG. 11H may be a microelectronic assembly 100, as shown. Further operations may be performed on the assembly of FIG. 11H. For example, electrically coupling the die 114-1, 114-2 to the first substrate 148-1 by forming interconnects 150 and overmolding the die 114-1, 114-2 with an insulating material 133, depositing solder 136 on a bottom surface of conductive contacts 172 of the second substrate 148-2, and/or electrically coupling solder 136 to a circuit board 131 to form interconnects 190, similar to the microelectronic assembly 100 of FIG. 2.

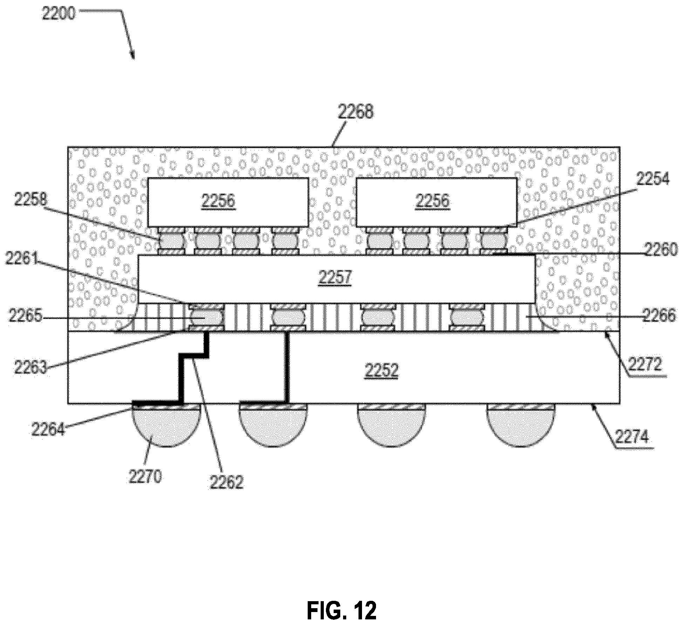

The packages disclosed herein, e.g., any of the microelectronic assemblies 100, or any further embodiments described herein, may be included in any suitable electronic component. FIGS. 12-14 illustrate various examples of packages, assemblies, and devices that may be used with or include any of the IC packages as disclosed herein.

FIG. 12 is a side, cross-sectional view of an example IC package 2200 that may include microelectronic assemblies in accordance with any of the embodiments disclosed herein. In some embodiments, the IC package 2200 may be a system-in-package (SiP).

As shown in FIG. 12, package support 2252 may be formed of an insulator (e.g., a ceramic, a buildup film, an epoxy film having filler particles therein, etc.), and may have conductive pathways extending through the insulator between first face 2272 and second face 2274, or between different locations on first face 2272, and/or between different locations on second face 2274. These conductive pathways may take the form of any of the interconnect structures comprising lines and/or vias, e.g., as discussed above with reference to FIG. 1.

Package support 2252 may include conductive contacts 2263 that are coupled to conductive pathway 2262 through package support 2252, allowing circuitry within dies 2256 and/or interposer 2257 to electrically couple to various ones of conductive contacts 2264 (or to other devices included in package support 2252, not shown).

IC package 2200 may include interposer 2257 coupled to package support 2252 via conductive contacts 2261 of interposer 2257, first level interconnects (FLI) 2265, and conductive contacts 2263 of package support 2252. FLI 2265 illustrated in FIG. 12 are solder bumps, but any suitable FLI 2265 may be used, such as solder bumps, solder posts, or bond wires.

IC package 2200 may include one or more dies 2256 coupled to interposer 2257 via conductive contacts 2254 of dies 2256, FLI 2258, and conductive contacts 2260 of interposer 2257. In various embodiments, interposer 2257 may include glass layer 103 comprising glass as described herein. Conductive contacts 2260 may be coupled to conductive pathways (not shown) through interposer 2257, allowing circuitry within dies 2256 to electrically couple to various ones of conductive contacts 2261 (or to other devices included in interposer 2257, not shown). FLI 2258 illustrated in FIG. 12 are solder bumps, but any suitable FLI 2258 may be used, such as solder bumps, solder posts, or bond wires. As used herein, a "conductive contact" may refer to a portion of electrically conductive material (e.g., metal) serving as an interface between different components; conductive contacts may be recessed in, flush with, or extending away from a surface of a component, and may take any suitable form (e.g., a conductive pad or socket).

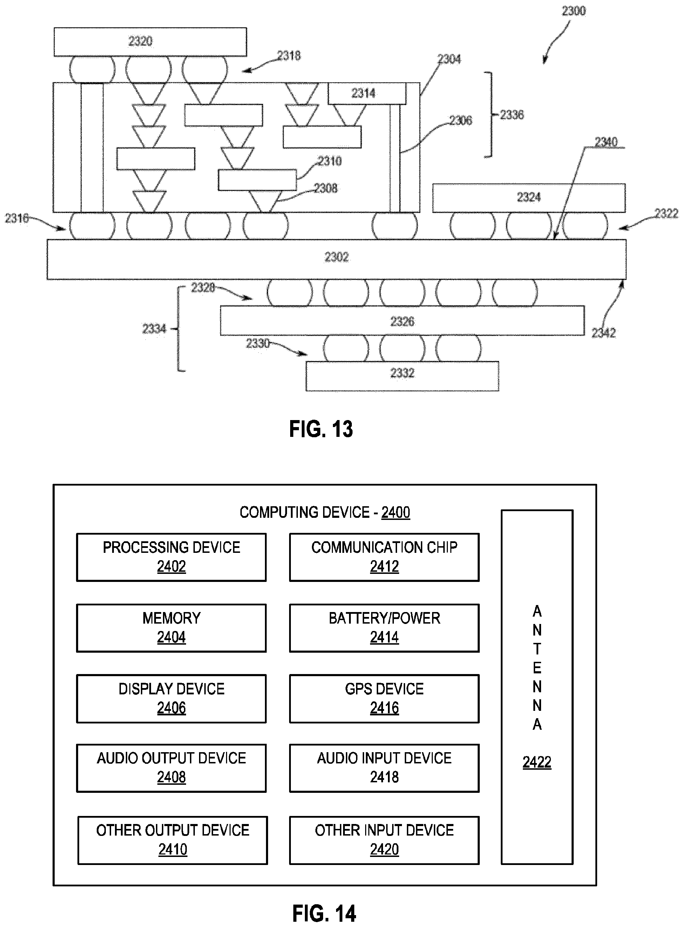

In some embodiments, underfill material 2266 may be disposed between package support 2252 and interposer 2257 around FLI 2265, and mold 2268 may be disposed around dies 2256 and interposer 2257 and in contact with package support 2252. In some embodiments, underfill material 2266 may be the same as mold 2268. Example materials that may be used for underfill material 2266 and mold 2268 are epoxies as suitable. Second level interconnects (SLI) 2270 may be coupled to conductive contacts 2264. SLI 2270 illustrated in FIG. 12 are solder balls (e.g., for a ball grid array (BGA) arrangement), but any suitable SLI 2270 may be used (e.g., pins in a pin grid array arrangement or lands in a land grid array arrangement). SLI 2270 may be used to couple IC package 2200 to another component, such as a circuit board (e.g., a motherboard), an interposer, or another IC package, as known in the art and as discussed below with reference to FIG. 14.

In embodiments in which IC package 2200 includes multiple dies 2256, IC package 2200 may be referred to as a multichip package (MCP). Dies 2256 may include circuitry to perform any desired functionality. For example, besides one or more of dies 2256 comprising components of dies 114 as described herein, one or more of dies 2256 may be logic dies (e.g., silicon-based dies), one or more of dies 2256 may be memory dies (e.g., high-bandwidth memory), etc. In some embodiments, at least some of dies 2256 may not include components of dies 114 as described herein.

Although IC package 2200 illustrated in FIG. 12 is a flip-chip package, other package architectures may be used. For example, IC package 2200 may be a BGA package, such as an embedded wafer-level ball grid array (eWLB) package. In another example, IC package 2200 may be a wafer-level chip scale package (WLCSP) or a panel fan-out (FO) package. Although two dies 2256 are illustrated in IC package 2200, IC package 2200 may include any desired number of dies 2256. IC package 2200 may include additional passive components, such as surface-mount resistors, capacitors, and inductors disposed over first face 2272 or second face 2274 of package support 2252, or on either face of interposer 2257. More generally, IC package 2200 may include any other active or passive components known in the art.

FIG. 13 is a cross-sectional side view of an IC device assembly 2300 that may include components having one or more microelectronic assembly 100 in accordance with any of the embodiments disclosed herein. IC device assembly 2300 includes a number of components disposed over a circuit board 2302 (which may be, e.g., a motherboard). IC device assembly 2300 includes components disposed over a first face 2340 of circuit board 2302 and an opposing second face 2342 of circuit board 2302; generally, components may be disposed over one or both faces 2340 and 2342. In particular, any suitable ones of the components of IC device assembly 2300 may include any of the one or more microelectronic assembly 100 in accordance with any of the embodiments disclosed herein; e.g., any of the IC packages discussed below with reference to IC device assembly 2300 may take the form of any of the embodiments of IC package 2200 discussed above with reference to FIG. 12.

In some embodiments, circuit board 2302 may be a PCB including multiple metal layers separated from one another by layers of insulator and interconnected by electrically conductive vias. Any one or more of the metal layers may be formed in a desired circuit pattern to route electrical signals (optionally in conjunction with other metal layers) between the components coupled to circuit board 2302. In other embodiments, circuit board 2302 may be a non-PCB package support.

FIG. 13 illustrates that, in some embodiments, IC device assembly 2300 may include a package-on-interposer structure 2336 coupled to first face 2340 of circuit board 2302 by coupling components 2316. Although not shown so as not to clutter the drawing, package-on-interposer structure 2336 may comprise a core, such as glass layer 103 in some embodiments. In other embodiments, package-on-interposer structure 2336 may not comprise a core. Coupling components 2316 may electrically and mechanically couple package-on-interposer structure 2336 to circuit board 2302, and may include solder balls (as shown), male and female portions of a socket, an adhesive, an underfill material, and/or any other suitable electrical and/or mechanical coupling structure.

Package-on-interposer structure 2336 may include IC package 2320 coupled to interposer 2304 by coupling components 2318. In some embodiments, IC package 2320 may comprise microelectronic assembly 100, including a strengthened glass layer 103, and other components as described herein, which are not shown so as not to clutter the drawing. Coupling components 2318 may take any suitable form depending on desired functionalities, such as the forms discussed above with reference to coupling components 2316. In some embodiments, IC package 2320 may be or include IC package 2200, e.g., as described above with reference to FIG. 12.

Although a single IC package 2320 is shown in FIG. 13, multiple IC packages may be coupled to interposer 2304; indeed, additional interposers may be coupled to interposer 2304. Interposer 2304 may provide an intervening package support used to bridge circuit board 2302 and IC package 2320. Generally, interposer 2304 may redistribute a connection to a wider pitch or reroute a connection to a different connection. For example, interposer 2304 may couple IC package 2320 to a BGA of coupling components 2316 for coupling to circuit board 2302.

In the embodiment illustrated in FIG. 13, IC package 2320 and circuit board 2302 are attached to opposing sides of interposer 2304. In other embodiments, IC package 2320 and circuit board 2302 may be attached to a same side of interposer 2304. In some embodiments, three or more components may be interconnected by way of interposer 2304.

Interposer 2304 may be formed of an epoxy resin, a fiberglass reinforced epoxy resin, a ceramic material, or a polymer material such as polyimide. In some implementations, interposer 2304 may be formed of alternate rigid or flexible materials that may include the same materials described above for use in a semiconductor substrate, such as silicon, germanium, and other group III-V and group IV materials. Interposer 2304 may include metal interconnects 2308 and vias 2310, including TSVs 2306. Interposer 2304 may further include embedded devices 2314, including both passive and active devices. Such devices may include, but are not limited to, capacitors, decoupling capacitors, resistors, inductors, fuses, diodes, transformers, sensors, electrostatic discharge (ESD) devices, and memory devices. More complex devices such as radio frequency (RF) devices, power amplifiers, power management devices, antennas, arrays, sensors, and microelectromechanical systems (MEMS) devices may also be formed on interposer 2304. Package-on-interposer structure 2336 may take the form of any of the package-on-interposer structures known in the art.

In some embodiments, IC device assembly 2300 may include an IC package 2324 coupled to first face 2340 of circuit board 2302 by coupling components 2322. Coupling components 2322 may take the form of any of the embodiments discussed above with reference to coupling components 2316, and IC package 2324 may take the form of any of the embodiments discussed above with reference to IC package 2320.

In some embodiments, IC device assembly 2300 may include a package-on-package structure 2334 coupled to second face 2342 of circuit board 2302 by coupling components 2328. Package-on-package structure 2334 may include an IC package 2326 and an IC package 2332 coupled together by coupling components 2330 such that IC package 2326 is disposed between circuit board 2302 and IC package 2332. Coupling components 2328 and 2330 may take the form of any of the embodiments of coupling components 2316 discussed above, and IC packages 2326 and/or 2332 may take the form of any of the embodiments of IC package 2320 discussed above. Package-on-package structure 2334 may be configured in accordance with any of the package-on-package structures known in the art.

FIG. 14 is a block diagram of an example computing device 2400 that may include one or more components having one or more IC packages in accordance with any of the embodiments disclosed herein. For example, any suitable ones of the components of computing device 2400 may include microelectronic assembly 100 including a strengthened glass layer 103 comprising glass in accordance with any of the embodiments disclosed herein. In another example, any one or more of the components of computing device 2400 may include any embodiments of IC package 2200 (e.g., as shown in FIG. 12). In yet another example, any one or more of the components of computing device 2400 may include an IC device assembly 2300 (e.g., as shown in FIG. 13).

A number of components are illustrated in FIG. 14 as included in computing device 2400, but any one or more of these components may be omitted or duplicated, as suitable for the application. In some embodiments, some or all of the components included in computing device 2400 may be attached to one or more motherboards. In some embodiments, some or all of these components are fabricated onto a single SOC die.

Additionally, in various embodiments, computing device 2400 may not include one or more of the components illustrated in FIG. 14, but computing device 2400 may include interface circuitry for coupling to the one or more components. For example, computing device 2400 may not include a display device 2406, but may include display device interface circuitry (e.g., a connector and driver circuitry) to which display device 2406 may be coupled. In another set of examples, computing device 2400 may not include an audio input device 2418 or an audio output device 2408, but may include audio input or output device interface circuitry (e.g., connectors and supporting circuitry) to which audio input device 2418 or audio output device 2408 may be coupled.

Computing device 2400 may include a processing device 2402 (e.g., one or more processing devices). As used herein, the term "processing device" or "processor" may refer to any device or portion of a device that processes electronic data from registers and/or memory to transform that electronic data into other electronic data that may be stored in registers and/or memory. Processing device 2402 may include one or more digital signal processors (DSPs), ASICs, CPUs, GPUs, cryptoprocessors (specialized processors that execute cryptographic algorithms within hardware), server processors, or any other suitable processing devices. Computing device 2400 may include a memory 2404, which may itself include one or more memory devices such as volatile memory (e.g., dynamic random access memory (DRAM)), nonvolatile memory (e.g., read-only memory (ROM)), flash memory, solid state memory, and/or a hard drive. In some embodiments, memory 2404 may include memory that shares a die with processing device 2402. This memory may be used as cache memory and may include embedded dynamic random access memory (eDRAM) or spin transfer torque magnetic random access memory (STT-MRAM).

In some embodiments, computing device 2400 may include a communication chip 2412 (e.g., one or more communication chips; note that the terms "chip," "die," and "IC die" are used interchangeably herein). For example, communication chip 2412 may be configured for managing wireless communications for the transfer of data to and from computing device 2400. The term "wireless" and its derivatives may be used to describe circuits, devices, systems, methods, techniques, communications channels, etc., that may communicate data through the use of modulated electromagnetic radiation through a nonsolid medium. The term does not imply that the associated devices do not contain any wires, although in some embodiments they might not.

Communication chip 2412 may implement any of a number of wireless standards or protocols, including Institute for Electrical and Electronic Engineers (IEEE) standards including Wi-Fi (IEEE 802.11 family), IEEE 802.16 standards (e.g., IEEE 802.16-2005 Amendment), Long-Term Evolution (LTE) project along with any amendments, updates, and/or revisions (e.g., advanced LTE project, ultramobile broadband (UMB) project (also referred to as "3GPP2"), etc.). IEEE 802.16 compatible Broadband Wireless Access (BWA) networks are generally referred to as WiMAX networks, an acronym that stands for Worldwide Interoperability for Microwave Access, which is a certification mark for products that pass conformity and interoperability tests for the IEEE 802.16 standards. The communication chip 2412 may operate in accordance with a Global System for Mobile Communication (GSM), General Packet Radio Service (GPRS), Universal Mobile Telecommunications System (UMTS), High-Speed Packet Access (HSPA), Evolved HSPA (E-HSPA), or LTE network. The communication chip 2412 may operate in accordance with Enhanced Data for GSM Evolution (EDGE), GSM EDGE Radio Access Network (GERAN), Universal Terrestrial Radio Access Network (UTRAN), or Evolved UTRAN (E-UTRAN). Communication chip 2412 may operate in accordance with Code Division Multiple Access (CDMA), Time Division Multiple Access (TDMA), Digital Enhanced Cordless Telecommunications (DECT), Evolution-Data Optimized (EV-DO), and derivatives of it, as well as any other wireless protocols that are designated as 3G, 4G, 5G, and beyond. Communication chip 2412 may operate in accordance with other wireless protocols in other embodiments. Computing device 2400 may include an antenna 2422 to facilitate wireless communications and/or to receive other wireless communications (such as AM or FM radio transmissions).

In some embodiments, communication chip 2412 may manage wired communications, such as electrical, optical, or any other suitable communication protocols (e.g., the Ethernet). As noted above, communication chip 2412 may include multiple communication chips. For instance, a first communication chip 2412 may be dedicated to shorter-range wireless communications such as Wi-Fi or Bluetooth, and a second communication chip 2412 may be dedicated to longer-range wireless communications such as global positioning system (GPS), EDGE, GPRS, CDMA, WiMAX, LTE, EV-DO, or others. In some embodiments, a first communication chip 2412 may be dedicated to wireless communications, and a second communication chip 2412 may be dedicated to wired communications.

Computing device 2400 may include battery/power circuitry 2414. Battery/power circuitry 2414 may include one or more energy storage devices (e.g., batteries or capacitors) and/or circuitry for coupling components of computing device 2400 to an energy source separate from computing device 2400 (e.g., AC line power).

Computing device 2400 may include a display device 2406 (or corresponding interface circuitry, as discussed above). Display device 2406 may include any visual indicators, such as a heads-up display, a computer monitor, a projector, a touchscreen display, a liquid crystal display (LCD), a light-emitting diode display, or a flat panel display, for example.

Computing device 2400 may include audio output device 2408 (or corresponding interface circuitry, as discussed above). Audio output device 2408 may include any device that generates an audible indicator, such as speakers, headsets, or earbuds, for example.

Computing device 2400 may include audio input device 2418 (or corresponding interface circuitry, as discussed above). Audio input device 2418 may include any device that generates a signal representative of a sound, such as microphones, microphone arrays, or digital instruments (e.g., instruments having a musical instrument digital interface (MIDI) output).

Computing device 2400 may include a GPS device 2416 (or corresponding interface circuitry, as discussed above). GPS device 2416 may be in communication with a satellite-based system and may receive a location of computing device 2400, as known in the art.

Computing device 2400 may include other output device 2410 (or corresponding interface circuitry, as discussed above). Examples of other output device 2410 may include an audio codec, a video codec, a printer, a wired or wireless transmitter for providing information to other devices, or an additional storage device.

Computing device 2400 may include other input device 2420 (or corresponding interface circuitry, as discussed above). Examples of other input device 2420 may include an accelerometer, a gyroscope, a compass, an image capture device, a keyboard, a cursor control device such as a mouse, a stylus, a touchpad, a bar code reader, a Quick Response (QR) code reader, any sensor, or a radio frequency identification (RFID) reader.

Computing device 2400 may have any desired form factor, such as a handheld or mobile computing device (e.g., a cell phone, a smart phone, a mobile internet device, a music player, a tablet computer, a laptop computer, a netbook computer, an ultrabook computer, a personal digital assistant (PDA), an ultramobile personal computer, etc.), a desktop computing device, a server or other networked computing component, a printer, a scanner, a monitor, a set-top box, an entertainment control unit, a vehicle control unit, a digital camera, a digital video recorder, or a wearable computing device. In some embodiments, computing device 2400 may be any other electronic device that processes data.

The above description of illustrated implementations of the disclosure, including what is described in the abstract, is not intended to be exhaustive or to limit the disclosure to the precise forms disclosed. While specific implementations of, and examples for, the disclosure are described herein for illustrative purposes, various equivalent modifications are possible within the scope of the disclosure, as those skilled in the relevant art will recognize.

The following paragraphs provide various examples of the embodiments disclosed herein.

Example 1 is a microelectronic assembly, including a glass layer having a first surface and an opposing second surface, the glass layer including a through-glass via (TGV); a first material on the first surface of the glass layer, the first material including a dielectric material, a mold material, or an epoxy material; a first conductive via extending through the first material, wherein the first conductive via has tapered sides and a smaller cross-section towards the first surface of the glass layer, wherein the first conductive via is electrically coupled to the TGV; a first dielectric layer on the first material, the first dielectric layer including a first conductive pathway electrically coupled to the first conductive via; a second material on the second surface of the glass layer, the second material including an organic dielectric, a mold material, or an epoxy material; a second conductive via extending through the second material, wherein the second conductive via has tapered sides and a larger cross-section towards the second surface of the glass layer, wherein the second conductive via is electrically coupled to the TGV; and a second dielectric layer on the second material, the second dielectric layer including a second conductive pathway electrically coupled to the second conductive via.

Example 2 may include the subject matter of Example 1, and may further specify that a thickness of the first material is between 5 microns and 100 microns.

Example 3 may include the subject matter of Example 1 or 2, and may further specify that a thickness of the second material is between 5 microns and 100 microns.

Example 4 may include the subject matter of any of Examples 1-3, and may further specify that a thickness of the glass layer is between 50 microns and 1500 microns.

Example 5 may include the subject matter of any of Examples 1-4, and may further include a liner between the first conductive via and the first conductive pathway, wherein a material of the liner includes titanium, nickel, palladium, or gold.

Example 6 may include the subject matter of Example 5, and may further specify that a thickness of the liner is between 50 nanometers and 2 microns.

Example 7 may include the subject matter of any of Examples 1-6, and may further include a die electrically coupled to the first conductive pathway in the first dielectric layer.

Example 8 is a microelectronic assembly, including a glass layer having a first surface and an opposing second surface; a first material on the first surface of the glass layer, the first material including a dielectric material, a mold material, or an epoxy material; a second material on the second surface of the glass layer, the second material including an organic dielectric, a mold material, or an epoxy material; a via extending through the glass layer, the first material, and the second material, the via including a conductive material; a first substrate on the first material, the first substrate including first conductive pathways with first metal layers having a first thickness, wherein an individual first conductive pathway is electrically coupled to the via; and a second substrate on the second material, the second substrate including second conductive pathways with second metal layers having a second thickness different than the first thickness, wherein an individual second conductive pathway is electrically coupled to the via.

Example 9 may include the subject matter of Example 8, and may further specify that the second thickness is greater than the first thickness.

Example 10 may include the subject matter of Example 8 or 9, and may further specify that the first substrate has a first number of metal layers and the second substrate has a second number of metal layers different than the first number of metal layers.

Example 11 may include the subject matter of any of Examples 8-10, and may further specify that a thickness of the glass layer is between 50 microns and 1500 microns.

Example 12 may include the subject matter of any of Examples 8-11, and may further include a die electrically coupled to the first substrate.

Example 13 may include the subject matter of any of Examples 8-12, and may further include a circuit board electrically coupled to the second substrate.

Example 14 is a microelectronic assembly, including a first glass layer having a first surface and an opposing second surface, the first glass layer including a first through-glass via (TGV); a first substrate on the first surface of the first glass layer, the first substrate including a first conductive pathway electrically coupled to the first TGV; a second glass layer having a first surface and an opposing second surface, the second glass layer including a second TGV; and a second substrate on the second surface of the second glass layer the second substrate including a second conductive pathway electrically coupled to the second TGV, wherein the first TGV at the second surface of the first glass layer is electrically coupled to the second TGV at the first surface of the second glass layer by an interconnect including solder.

Example 15 may include the subject matter of Example 14, and may further include an insulating material between the second surface of the first glass layer and the first surface of the second glass layer around the interconnect.

Example 16 may include the subject matter of Example 15, and may further specify that the insulating material includes an underfill material, a capillary underfill, an epoxy material, non-conductive film (NCF), or molded underfill.

Example 17 may include the subject matter of Example 15 or 16, and may further include an adhesive material between the second surface of the first glass layer and the insulating material or between the first surface of the second glass layer and the insulating material.

Example 18 may include the subject matter of any of Examples 14-17, and may further specify that a thickness of the glass layer is between 50 microns and 1500 microns.

Example 19 may include the subject matter of any of Examples 14-18, and may further include a die electrically coupled to the first substrate.

Example 20 may include the subject matter of any of Examples 14-19, and may further include a circuit board electrically coupled to the second substrate.

Example 21 is a method of manufacturing a microelectronic assembly, including attaching a glass layer to a carrier, wherein the glass layer is removably attached to the carrier and the carrier includes a notch; forming a substrate having conductive pathways through a dielectric material; removing the carrier from the glass layer; and removing the glass layer from the substrate.

Example 22 may include the subject matter of Example 21, and may further specify that the substrate is formed using a printed circuit board technique or a redistribution layer technique.

Example 23 may include the subject matter of Example 21 or 22, and may further specify that the carrier includes a peelable core and a first metal layer on a surface of the carrier, and wherein attaching the glass layer to the carrier includes depositing a conductive adhesive on the first metal layer on the surface of the carrier; depositing a second metal layer on the conductive adhesive; depositing a first release layer on the second metal layer; depositing the glass layer on the second metal layer; depositing a second release layer on the glass layer; and depositing a third metal layer on the second release layer.

Example 24 may include the subject matter of Example 23, and may further include removing a portion of the conductive adhesive and the second metal layer along a perimeter of the carrier to form an inset.

Example 25 may include the subject matter of Example 23 or 24, and may further specify that the second metal layer and the third metal layer are deposited by electroplating.

Example 26 may include the subject matter of any of Examples 23-25, and may further specify that the first release layer includes a thermal debonding film or a laser debonding film.

Example 27 may include the subject matter of any of Examples 23-26, and may further specify that the second release layer includes a thermal debonding film or a laser debonding film.

Example 28 may include the subject matter of any of Examples 23-27, and may further specify that removing the carrier from the glass layer includes sawing along saw streets and peeling off the conductive adhesive.

Example 29 may include the subject matter of any of Examples 23-28, and may further specify that removing the glass layer includes removing the second release layer.

Example 30 may include the subject matter of any of Examples 23-29, and may further include removing the second metal layer from the first release layer.

Example 31 may include the subject matter of Example 30, and may further specify that removing the second metal layer includes using a chemical etching technique.

Example 32 may include the subject matter of any of Examples 23-31, and may further include removing the third metal layer from the substrate.

Example 33 may include the subject matter of Example 32, and may further specify that removing the third metal layer includes using a chemical etching technique.

Example 34 may include the subject matter of Example 21 or 22, and may further specify that the carrier includes a non-peelable core and a first metal layer on a surface of the carrier, and wherein attaching the glass layer to the carrier includes depositing a first release layer on the first metal layer; depositing the glass layer on the first release layer; depositing a second release layer on the glass layer; and depositing a second metal layer on the second release layer.

Example 35 may include the subject matter of Example 34, and may further specify that the second metal layer is deposited by electroplating.

Example 36 may include the subject matter of Example 34 or 35, and may further specify that a material of the second metal layer includes copper.

Example 37 may include the subject matter of any of Examples 34-36, and may further specify that the first release layer includes a thermal debonding film.

Example 38 may include the subject matter of any of Examples 34-37, and may further specify that the second release layer includes a thermal debonding film or a laser debonding film.

Example 39 may include the subject matter of any of Examples 34-38, and may further specify that removing the carrier from the glass layer includes removing the first release layer.

Example 40 may include the subject matter of any of Examples 34-39, and may further specify that removing the glass layer includes removing the second release layer.

Example 41 may include the subject matter of any of Examples 34-40, and may further include removing the second metal layer from the substrate.

Example 42 may include the subject matter of Example 41, and may further specify that removing the second metal layer includes using a chemical etching technique.

Example 43 is a microelectronic assembly, including a glass layer having a first surface and an opposing second surface; a first material on the first surface of the glass layer, the first material including a dielectric material, a mold material, or an epoxy material; a second material on the second surface of the glass layer, the second material including an organic dielectric, a mold material, or an epoxy material; a via extending through the glass layer, the first material, and the second material, the via including a conductive material; a first substrate on the first material, the first substrate including first conductive pathways with a first number of metal layers, wherein an individual first conductive pathway is electrically coupled to the via; and a second substrate on the second material, the second substrate including second conductive pathways with a second number of metal layers different than the first number of metal layers, wherein an individual second conductive pathway is electrically coupled to the via.

Example 44 may include the subject matter of Example 43, and may further specify that the first number of metal layers is greater than the second number of metal layers.

Example 45 may include the subject matter of Example 43 or 44, and may further specify that a thickness of the glass layer is between 50 microns and 1500 microns.

Example 46 may include the subject matter of any of Examples 43-45, and may further include a die electrically coupled to the first substrate.

Example 47 may include the subject matter of any of Examples 43-46, and may further include a circuit board electrically coupled to the second substrate.

## Claims

1. A microelectronic assembly, comprising:
a glass layer having a first surface and an opposing second surface, the glass layer including a through-glass via (TGV);
a first material on the first surface of the glass layer, the first material including a dielectric material, a mold material, or an epoxy material;
a first conductive via extending through the first material, wherein the first conductive via has tapered sides and a smaller cross-section towards the first surface of the glass layer, wherein the first conductive via is electrically coupled to the TGV;
a first dielectric layer on the first material, the first dielectric layer including a first conductive pathway electrically coupled to the first conductive via;
a second material on the second surface of the glass layer, the second material including an organic dielectric, a mold material, or an epoxy material;
a second conductive via extending through the second material, wherein the second conductive via has tapered sides and a larger cross-section towards the second surface of the glass layer, wherein the second conductive via is electrically coupled to the TGV; and
a second dielectric layer on the second material, the second dielectric layer including a second conductive pathway electrically coupled to the second conductive via.

2. The microelectronic assembly of claim 1, wherein a thickness of the first material is between 5 microns and 100 microns, and , wherein a thickness of the second material is between 5 microns and 100 microns.

3. The microelectronic assembly of claim 1 or 2, wherein a thickness of the glass layer is between 50 microns and 1500 microns.

4. The microelectronic assembly of any one of claims 1-3, further comprising:
a liner between the first conductive via and the first conductive pathway, wherein a material of the liner includes titanium, nickel, palladium, or gold.

5. The microelectronic assembly of claim 4, wherein a thickness of the liner is between 50 nanometers and 2 microns.

6. An integrated circuit (IC) package, comprising:
a glass layer having a first surface and an opposing second surface;
a first material on the first surface of the glass layer, the first material including a dielectric material, a mold material, or an epoxy material;
a second material on the second surface of the glass layer, the second material including an organic dielectric, a mold material, or an epoxy material;
a via extending through the glass layer, the first material, and the second material, the via including a conductive material;
a first substrate on the first material, the first substrate including first conductive pathways with first metal layers having a first thickness, wherein an individual first conductive pathway is electrically coupled to the via; and
a second substrate on the second material, the second substrate including second conductive pathways with second metal layers having a second thickness different than the first thickness, wherein an individual second conductive pathway is electrically coupled to the via.

7. The IC package of claim 6, wherein the second thickness is greater than the first thickness.

8. The IC package of claim 6 or 7, wherein the first substrate has a first number of metal layers and the second substrate has a second number of metal layers different than the first number of metal layers.

9. The IC package of any one of claims 6-8, wherein a thickness of the glass layer is between 50 microns and 1500 microns.

10. The IC package of any one of claims 6-9, further comprising:
a die electrically coupled to the first substrate.

11. A computing device, comprising:
a first glass layer having a first surface and an opposing second surface, the first glass layer including a first through-glass via (TGV);
a first substrate on the first surface of the first glass layer, the first substrate including a first conductive pathway electrically coupled to the first TGV;
a second glass layer having a first surface and an opposing second surface, the second glass layer including a second TGV; and
a second substrate on the second surface of the second glass layer the second substrate including a second conductive pathway electrically coupled to the second TGV, wherein the first TGV at the second surface of the first glass layer is electrically coupled to the second TGV at the first surface of the second glass layer by an interconnect including solder.

12. The computing device of claim 11, further comprising:
an insulating material between the second surface of the first glass layer and the first surface of the second glass layer around the interconnect.

13. The computing device of claim 12, wherein the insulating material includes an underfill material, a capillary underfill, an epoxy material, non-conductive film (NCF), or molded underfill.

14. The computing device of claim 12, further comprising:
an adhesive material between the second surface of the first glass layer and the insulating material or between the first surface of the second glass layer and the insulating material.

15. The computing device of any one of claims 11-14, further comprising:
a die electrically coupled to the first substrate.
